(19) Europäisches Patentamt / European Patent Office / Office européen des brevets

(11) EP 2 874 181 A1

(12) # EUROPEAN PATENT APPLICATION
published in accordance with Art. 153(4) EPC

(43) Date of publication:
**20.05.2015 Bulletin 2015/21**

(21) Application number: **13816898.4**

(22) Date of filing: **12.07.2013**

(51) Int Cl.:
***H01L 21/316*** *(2006.01)* ***H01L 21/312*** *(2006.01)*
***H01L 31/04*** *(2014.01)*

(86) International application number:
**PCT/JP2013/069223**

(87) International publication number:
**WO 2014/010744 (16.01.2014 Gazette 2014/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.07.2012 JP 2012156472**

(71) Applicant: **Hitachi Chemical Company, Ltd.**
**Chiyoda-ku**
**Tokyo 100-6606 (JP)**

(72) Inventors:
- **TANAKA, Tooru**
  **Tsukuba-shi**
  **Ibaraki 300-4247 (JP)**
- **YOSHIDA, Masato**
  **Tsukuba-shi**
  **Ibaraki 300-4247 (JP)**
- **KURATA, Yasushi**
  **Tsukuba-shi**
  **Ibaraki 300-4247 (JP)**
- **ORITA, Akihiro**
  **Tsukuba-shi**
  **Ibaraki 300-4247 (JP)**
- **SATO, Tetsuya**
  **Tsukuba-shi**
  **Ibaraki 300-4247 (JP)**
- **HAYASAKA, Tsuyoshi**
  **Tsukuba-shi**
  **Ibaraki 300-4247 (JP)**

(74) Representative: **Hoffmann Eitle**
**Patent- und Rechtsanwälte PartmbB**
**Arabellastraße 30**
**81925 München (DE)**

(54) **COMPOSITION FOR FORMATION OF PASSIVATION LAYER, SEMICONDUCTOR SUBSTRATE WITH PASSIVATION LAYER, METHOD FOR MANUFACTURING SEMICONDUCTOR SUBSTRATE WITH PASSIVATION LAYER, SOLAR CELL ELEMENT, METHOD FOR MANUFACTURING SOLAR CELL ELEMENT, AND SOLAR CELL**

(57) The composition for forming a passivation layer includes an organic aluminum compound represented by Formula (I) and an organic compound represented by Formula (II). In Formula (I), each $R^1$ independently represents an alkyl group having from 1 to 8 carbon atoms. n represents an integer from 0 to 3. Each of $X^2$ and $X^3$ independently represents an oxygen atom or a methylene group. Each of $R^2$, $R^3$ and $R^4$ independently represents a hydrogen atom, or an alkyl group having from 1 to 8 carbon atoms.

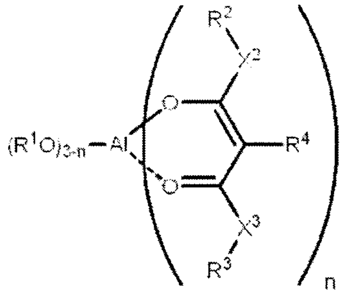

(I)

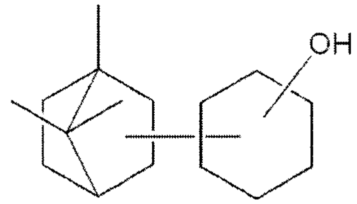

(II)

EP 2 874 181 A1

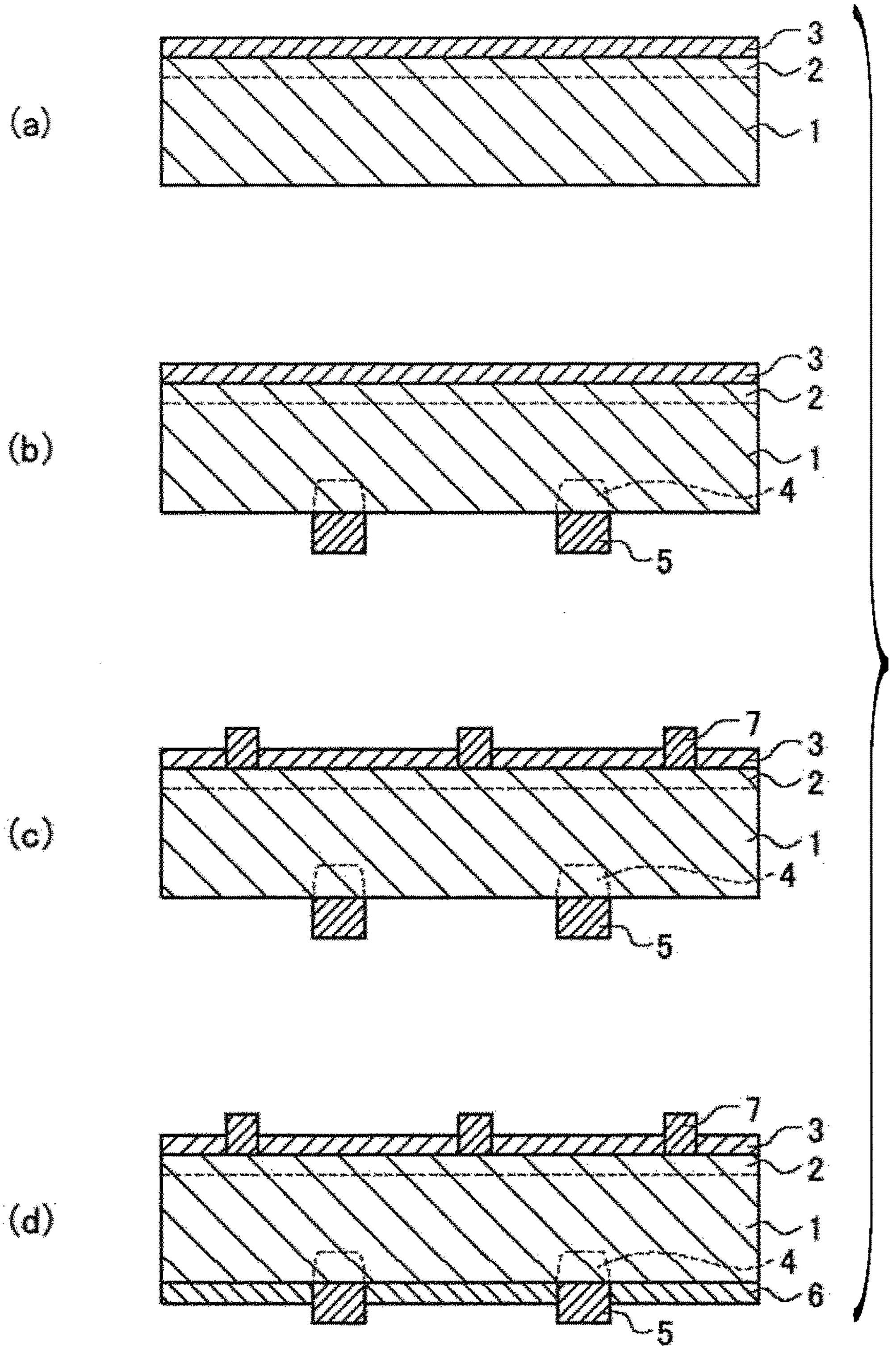


FIG.1

## Description

[Technical Field]

The present invention relates to a composition for forming a passivation layer, a semiconductor substrate with a passivation layer, a method of producing a semiconductor substrate with a passivation layer, a photovoltaic cell element, a method of producing a photovoltaic cell element, and a photovoltaic cell.

[Background Art]

A method of producing a conventional silicon photovoltaic cell element is explained.
First, in order to improve an optical confinement so as to improve efficiency, a p-type silicon substrate having a textured structure formed on its light receiving surface is prepared, subsequently subjected to thermal treatment in a mixed gas atmosphere of phosphorus oxychloride ($POCl_3$), nitrogen, and oxygen at the temperature from 800°C to 900°C for several ten minutes to wholly form an n-type diffusion layer. In such a conventional method, phosphorus diffusion was conducted using a mixed gas, therefore an n-type diffusion layer is formed not only on a light-receiving surface, but also on back and side surfaces. Therefore, side etching is conducted to remove an n-type diffusion layer formed on a side surface. An n-type diffusion layer formed on a back surface needs to be converted into a $p^+$-type diffusion layer. Therefore, an aluminum paste is applied to the whole back surface, and then subjected to thermal treatment (calcination) to form an aluminum electrode, thereby converting an n-type diffusion layer into a $p^+$-type diffusion layer, and in a lump obtaining ohmic contact.
However, an aluminum electrode formed of an aluminum paste has low electric conductivity. Therefore, due to reduce sheet resistance, an aluminum electrode formed on a whole back surface should usually have a thickness from about 10 $\mu$m to 20 $\mu$m after thermal treatment (calcination). Furthermore, since coefficient of thermal expansion of silicon is greatly different from that of aluminum, as for a silicon substrate on which an aluminum electrode is formed, great internal stress is provided in the silicon substrate during a thermal treatment (calcination) and a cooling process, resulting in damage to crystal grain boundary, increased crystal defect, and warpage.
In order to solve this problem, there has been a method of reducing the amount of an aluminum paste to be applied and thinning an electrode layer on a back surface. However, reducing the amount of aluminum to be applied results in insufficient amount of aluminum diffusing from the surface to the inside of a p-type silicon semiconductor substrate. As a result, inability to obtain a desired BSF (Back Surface Field) effect (effect to enhance collection efficiency of a generated carrier by the existence of a $p^+$-type diffusion layer) presents a problem of degraded properties of a photovoltaic cell.
With reference to the above, a point contact method which involves applying an aluminum paste onto a portion of a silicon substrate surface to locally form a $p^+$-type diffusion layer and an aluminum electrode (e.g., Japanese Patent No. 3107287).
In the case of a photovoltaic cell with the point contact structure on a surface opposite to light-receiving surface (hereinafter referred to as a "back surface"), it is necessary to inhibit a recombination velocity of a minor carrier in the region other than the aluminum electrode on the surface. As a passivation layer for a back surface for the purpose, a $SiO_2$ film is suggested (see, for example, Japanese Patent Laid-Open No. 2004-6565). Passivation effect by forming such a $SiO_2$ film includes an effect to reduce surface level density, which causes atomic recombination, by terminating a dangling bond of a silicon atom in a back surface portion of a silicon substrate.
As another method to inhibit recombination of minor carrier, there has been a method to reduce a minor carrier density by the electric field where a fixed charge in the passivation layer generates. Such a passivation effect is generally called as electrical field effect, and an aluminum oxide ($Al_2O_3$) layer is suggested as a material having a negative fixed charge (see, for example, Japanese Patent No. 4767110).
Such a passivation layer is generally formed by a method such as ALD (Atomic Layer Deposition) method, CVD (Chemical Vapor Deposition) method, or the like (see, for example, Journal ofApplied Physics, 104 (2008), 113,703-1 to 113703-7). As a simple method of forming an oxidation aluminum layer on a semiconductor substrate, a method by sol-gel method is suggested (see, for example, Thin Solid Films, 517 (2009), 6327 to 6330, and Chinese Physics Letters, 26 (2009), 088102-1 to 088102-4).

SUMMARY OF INVENTION

[Technical Problem]

Since a method described in Journal of Applied Physics, 104 (2008), 113703-1 to 113,703-7 includes a complicated process such as vapor deposition, it is sometimes difficult to enhance productivity. A composition to be used

for a method of forming a passivation layer described in Thin Solid Films, 517 (2009), 6327 to 6330, and Chinese Physics Letters, 26 (2009), 088102-1 to 088102-4, causes trouble such as gelation over time, resulting in storage stability which is far from satisfactory.

In order to solve these problems, the present inventors have developed a particular composition for forming a passivation layer including a binder resin such as ethyl cellulose. Such a particular composition for forming a passivation layer has an effect to enhance printability when applied to a semiconductor substrate.

However, when a particular composition for forming a passivation layer is subjected to thermal treatment (calcination) to form a passivation layer, a binder resin is required to be subjected to thermal treatment (calcination) to defat (to remove the binder resin content), so the thermal treatment (calcination) requires a long period of time or high temperature.

When a composition containing a binder resin for forming a particular passivation layer is used, the black residue including a carbon ingredient generates after thermal treatment (calcination), accordingly a treatment to remove the residue is needed after the thermal treatment (calcination), and it tends to be difficult to improve productivity. Furthermore, a passivation effect by the electric field effect is far from satisfactory because, use of a composition containing a binder resin for forming a particular passivation layer tends to form a passivation layer in which a void is generated or to inhomogeneously form a passivation layer.

The present invention has been made considering the conventional problems described above, and aims at enabling formation of a passivation layer having a desired shape by a simple method, and providing a composition for forming a passivation layer with sufficient passivation effect while inhibiting generation of a black residue. Further, the present invention aims at providing a semiconductor substrate with a passivation layer using a composition for forming a passivation layer, a method of producing a semiconductor substrate with a passivation layer, a photovoltaic cell element, a method of the photovoltaic cell element and a photovoltaic cell, using a composition for forming a passivation layer of the present invention.

[Solution to Problems]

The specific means to solve the above problem is as follows.

<1> A composition for forming a passivation layer, including an organic aluminum compound represented by the following Formula (I) and an organic compound represented by the following Formula (II).

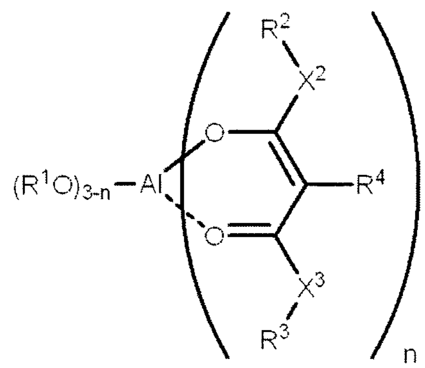

(I)

In Formula (I), each $R^1$ independently represents an alkyl group having from 1 to 8 carbon atoms. n represents an integer from 0 to 3. Each of $X^2$ and $X^3$ independently represents an oxygen atom or a methylene group. Each of $R^2$, $R^3$ and $R^4$ independently represents a hydrogen atom, or an alkyl group having from 1 to 8 carbon atoms.

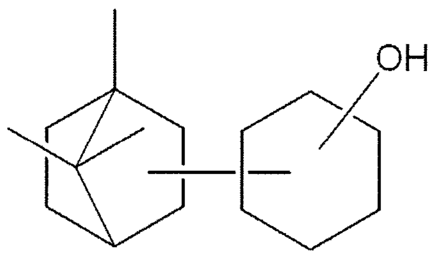

(II)

<2> The composition for forming a passivation layer according to the above <1>, in which each $R^1$ in Formula (I) is independently an alkyl group having from 1 to 4 carbon atoms.
<3> The composition for forming a passivation layer according to the above <1> or <2>, in which n in Formula (I) is an integer from 1 to 3.
<4> The composition for forming a passivation layer according to any one of the above <1> to <3>, in which the content ratio of Formula (II) is from 30% by mass to 99.9% by mass with respect to 100% by mass of the composition for forming a passivation layer.
<5> A semiconductor substrate with a passivation layer, including:

a semiconductor substrate; and
a passivation layer, which is provided on an entire or partial surface of the semiconductor substrate, and which is a resultant of subjecting the composition for forming a passivation layer according to any one of the above <1> to <4> to a thermal treatment.

<6> A method of producing a semiconductor substrate with a passivation layer, including:

applying the composition for forming a passivation layer according to any one of the above <1> to <4> onto an entire or partial surface of a semiconductor substrate to form a composition layer; and
subjecting the composition layer to a thermal treatment to form a passivation layer.

<7> A photovoltaic cell element, including:

a semiconductor substrate composed of a p-type layer and an n-type layer connected by a p-n junction;
a passivation layer, which is provided on an entire or partial surface of the semiconductor substrate, and which is a resultant of subjecting the composition for forming a passivation layer according to any one of the above <1> to <4> to a thermal treatment; and
an electrode provided on one or more layers selected from the group consisting of the p-type layer and the n-type layer.

<8> A method of producing a photovoltaic cell element, including:

applying the composition for forming a passivation layer according to any one of the above <1> to <4> onto at least a portion of a surface having an electrode of a semiconductor substrate, the semiconductor substrate comprising a p-n junction composed of a p-type layer and an n-type layer that are connected, and the electrode on one or more layers selected from the group consisting of the p-ype layer and the n-type layer; and
subjecting the composition layer to a thermal treatment to form a passivation layer.

<9> A photovoltaic cell, including:

the photovoltaic cell element according to the above <7>, and
a wiring material provided on the electrode of the photovoltaic cell element.

[Advantageous Effects of Invention]

By the present invention, a composition for forming a passivation layer can be provided, which can form a passivation layer having a desired shape by a simple method, and provide a sufficient passivation effect while inhibiting generation of a black residue. A semiconductor substrate with a passivation layer, a method of producing a semiconductor substrate with a passivation layer, a photovoltaic cell element, a method of producing a photovoltaic cell element, and a photovoltaic cell can also be provided.

BRIEF DESCRIPTION OF DRAWINGS

Fig. 1 is a cross sectional view schematically showing an example of a method of producing a photovoltaic cell element with a passivation layer.
Fig. 2 is a cross sectional view schematically showing an example of a method of producing a photovoltaic cell element with a passivation layer.

Fig. 3 is a cross sectional view schematically showing a back contact electrode type photovoltaic cell element with a passivation layer.

DESCRIPTION OF EMBODIMENTS

The term "process" as used herein includes not only an independent process but also a process not clearly distinguishable from other so long as it can attain its object. The numerical value range expressed using "from...to..." denotes a range including each of the minimum value and the maximum value of the values described in this expression. Furthermore, in the case in which the plurality of the materials corresponding to each component are present in the composition, the amount of each component in the composition means a total amount of plural materials present in the composition unless otherwise specified. The term "layer", as used herein, includes a construction having an entirely formed shape as well as that having a partially formed shape, as seen in a plan view.

<Composition for forming a passivation layer>

A composition for forming a passivation layer of the present invention includes an organic aluminium compound represented by the following Formula (I) (hereinafter referred to as "a specific organic aluminum compound"), and an organic compound represented by the following Formula (II) (hereinafter referred to as "a compound of Formula (II)").

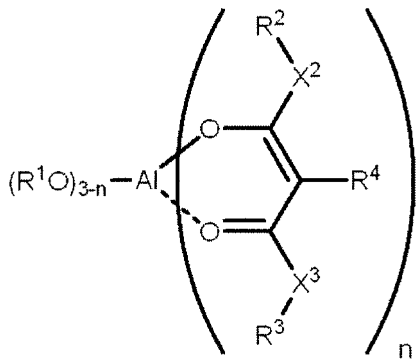

(I)

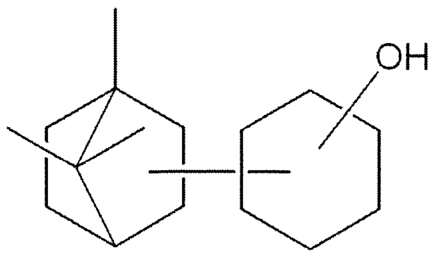

(II)

In Formula (I), each $R^1$ independently represents an alkyl group having from 1 to 8 carbon atoms. n represents an integer from 0 to 3. Each of $X^2$ and $X^3$ independently represents an oxygen atom or a methylene group. Each of $R^2$, $R^3$ and $R^4$ independently represents a hydrogen atom, or an alkyl group having from 1 to 8 carbon atoms.

A composition for forming a passivation layer including a specific organic aluminum compound and a compound of Formula (II) is applied to a semiconductor substrate to form a composition layer having a desired shape, which is subjected to thermal treatment (calcination), thereby forming a passivation layer having an excellent passivation effect in a desired shape. A method using a composition for forming a passivation layer of the present invention is a simple and highly-productive one without requiring a vapor deposition apparatus or the like. Furthermore, it can form a passivation layer in a desired shape without requiring a complicated process such as the masking. The composition for forming a passivation layer exhibits excellent storage stability over time while inhibiting generation of defects such as gelation by including a specific organic aluminum compound. A composition for forming a passivation layer of the present invention can form a composition layer with a desired shape by including an organic compound represented by Formula (II), whereas generation of a black residue is inhibited because an organic compound represented by Formula (II) can be eliminated by vaporizing it upon heating.

In the present specification, a passivation effect of a semiconductor substrate can be evaluated by measuring effective lifetime of a minor carrier in a semiconductor substrate on which a passivation layer is applied according to the

Microwave reflection Conductive Decay method using a device such as WT-2000PVN manufactured by SEMILAB JAPAN K.K.

Effective lifetime $\tau$ is represented by the following Formula (A) using a bulk lifetime $\tau_b$ of an inside a semiconductor substrate, and a surface lifetime $\tau_S$ of a surface of a semiconductor substrate. A small surface level density of the semiconductor substrate surface results in longer $\tau_S$, thereby providing longer effective lifetime $\tau$. When a defect such as dangling bond inside the semiconductor surface is reduced, a bulk lifetime $\tau_b$ becomes longer, providing a longer effective lifetime $\tau$. That is, measurement of effective lifetime $\tau$ enables evaluation of interfacial properties between the passivation layer and the semiconductor substrate, as well as internal properties of the semiconductor substrate such as dangling bond.

[0033] $1/\tau = 1/\tau_b + 1/\tau_S$ (A)

The longer effective lifetime $\tau$ means the slower recombination velocity of the minor carrier. The conversion efficiency can be improved by constituting a photovoltaic cell element using a semiconductor substrate having a long effective lifetime.

(Specific organic aluminum compound)

The composition for forming a passivation layer includes at least one kind of an organic aluminum compound (a specific organic aluminum compound) represented by Formula (I). The specific organic aluminum compound includes a compound called aluminum alkoxide, aluminum chelate, and preferably includes an aluminum chelate structure in addition to an aluminum alkoxide structure. An organic aluminum compound is converted to an aluminum oxide ($Al_2O_3$) by thermal treatment (calcination), as described in Nippon Seramikkusu Kyokai Gakujitsu Ronbunshi, 97 (1989), 369-399.

The inventors consider the reason why a composition for forming a passivation layer can form a passivation layer having an excellent passivation effect by including an organic aluminum compound represented by Formula (I) is as follows.

Aluminum oxide formed by thermal treatment (calcination) of a composition for forming a passivation layer containing a specific organic aluminum compound tends to become amorphous, and can possess a large negative fixed charge while generating a four-fold coordinated aluminum oxide layer near the interface. It is believed that a passivation layer having an excellent passivation effect can be obtained because such a large negative fixed charge generates an electric field near the interface of the semiconductor substrate to reduce concentration of a minor carrier, resulting in inhibited carrier recombination velocity at the interface.

On the semiconductor substrate surface, the state of four-fold coordinated aluminum oxide layer which is a causative species of the negative fixed charge can be determined by inspecting a combination mode at the section of the semiconductor substrate by Electron Energy Loss Spectroscopy (EELS) with a scanning type transmission electron microscope (STEM, Scanning Transmission electron Microscope). A four-fold coordinated aluminum oxide is thought to have a structure of silicon dioxide ($SiO_2$) whose a central silicon is isomorphously-substituted with an aluminum, and formed as a negative charge source at an interface between silicon oxide and aluminum oxide like zeolite and clay.

The entire state of the formed aluminum oxide can be determined by measuring an X-ray diffraction spectrum (XRD, X-ray diffraction). For example, it is confirmed to have an amorphous structure as its XRD does not exhibit a specific reflection pattern. Also, a negative fixed charge which aluminum oxide possesses can be evaluated by the CV method (Capacitance Voltage measurement). However, a surface level density of a passivation layer formed of a composition for forming a passivation layer of the present invention may be greater than that of an aluminum oxide layer formed by ALD or CVD method. However, a passivation layer formed of a composition for forming a passivation layer of the present invention has a greater electric field effect, reduced minor carrier concentration, and longer surface lifetime $\tau_S$. Therefore the surface level density is relatively less critical.

In Formula (I), each $R^1$ independently represents an alkyl group having from 1 to 8 carbon atoms, and preferably an alkyl group having from 1 to 4 carbon atoms. An alkyl group represented by $R^1$ may be straight or branched. Examples of an alkyl group represented by $R^1$ can typically include a methyl group, an ethyl group, a propyl group, an isopropyl group, a butyl, an iso-butyl, a sec-butyl, t-butyl, a hexyl group, an octyl group, a 2-ethyl hexyl group. Especially, an alkyl group represented by $R^1$ is preferably an unsubstituted alkyl group having from 1 to 8 carbon atoms, and more preferably an unsubstituted alkyl group having from 1 to 4 carbon atoms, from the viewpoint of storage stability and passivation effect.

In Formula (I), n represents an integer from 0 to 3. From the viewpoint of storage stability, n is preferably an integer from 1 to 3, and more preferably 1 or 3. Each of $X^2$ and $X^3$ independently represents an oxygen atom or a methylene group. From the viewpoint of storage stability, at least one of $X^2$ and $X^3$ is preferably an oxygen atom.

Each of $R^2$, $R^3$ and $R^4$ in Formula (I) independently represents a hydrogen atom or an alkyl group having from

1 to 8 carbon atoms. An alkyl group represented by $R^2$, $R^3$ and $R^4$ may be straight or branched. An alkyl group represented by $R^2$, $R^3$ and $R^4$ may be substituted or unsubstituted, and preferably unsubstituted. An alkyl group represented by $R^2$, $R^3$ and $R^4$ is an alkyl group having from 1 to 8 carbon atoms, and preferably an alkyl group having from 1 to 4 carbon atoms. Examples of an alkyl group represented by $R^2$, $R^3$ and $R^4$ typically include a methyl group, an ethyl group, a propyl group, an isopropyl group, a butyl, an iso-butyl, a sec-butyl, a t-butyl, a hexyl group, an octyl group, a 2-ethyl hexyl group.

Among them, from the viewpoint of storage stability and passivation effect, each of $R^2$ and $R^3$ in Formula (I) preferably independently represents a hydrogen atom or an unsubstituted alkyl group having from 1 to 8 carbon atoms, and more preferably a hydrogen atom or an unsubstituted alkyl group having from 1 to 4 carbon atoms.

From the viewpoint of storage stability and passivation effect, $R^4$ in Formula (I) is preferably a hydrogen atom or an unsubstituted alkyl group of having from 1 to 8 carbon atoms, and more preferably, a hydrogen atom or an unsubstituted alkyl group having from 1 to 4 carbon atoms.

In an organic aluminum compound represented by Formula (I), from the viewpoint of storage stability, it is preferable that n is from 1 to 3 and each $R^4$ independently represents a hydrogen atom or an alkyl group of having from 1 to 4 carbon atoms.

From the viewpoint of storage stability and passivation effect, an organic aluminum compound represented by Formula (I) is one selected from the group consisting of a compound in which n is 0, and each $R^1$ independently represents an alkyl group having from 1 to 4 carbon atoms; and a compound in which n is from 1 to 3, each $R^1$ independently represents an alkyl group having from 1 to 4 carbon atoms, and at least one of $X^2$ and $X^3$ is an oxygen atom, each of $R^2$ and $R^3$ independently represents a hydrogen atom or an alkyl group having from 1 to 4 carbon atoms, and each $R^4$ is independently a hydrogen atom or an alkyl group having from 1 to 4 carbon atoms.

It is more preferable that an organic aluminum compound represented by Formula (I) is one selected from the group consisting of a compound in which n is 0, and each $R^1$ is independently an unsubstituted alkyl group having from 1 to 4 carbon atoms; and a compound in which n is from 1 to 3, each $R^1$ independently represents an unsubstituted alkyl group having from 1 to 4 carbon atoms, at least one of $X^2$ and $X^3$ is an oxygen atom, and $R^2$ or $R^3$ bonded to the oxygen atom represents an alkyl group having from 1 to 4 carbon atoms, and where $X^2$ or $X^3$ is a methylene group, $R^2$ or $R^3$ bonded to the methylene group is a hydrogen atom, and $R^4$ represents a hydrogen atom.

Examples of a specific organic aluminum compound (aluminum trialkoxide) of Formula (I) in which n is 0 typically include trimethoxy aluminum, triethoxy aluminum, triisopropoxy aluminum, tri-sec-butoxy aluminum, mono-sec-butoxy-diisopropoxy aluminum, tri-t-butoxy aluminum, tri-n-butoxy aluminum.

Example of a specific organic aluminum compound of Formula (I) in which n is from 1 to 3 typically include aluminum ethyl acetoacetate diisopropylate [(ethyl acetoacetate) aluminum diisopropoxide)], tris(ethyl acetoacetate) aluminum.

A specific organic aluminum compound of Formula (I) in which n is from 1 to 3 may be used whether it may be prepared or commercially available. A commercially available product includes those of trade name ofALCH, ALCH-50F, ALCH-75, ALCH-TR, ALCH-TR-20 manufactured by Kawaken Fine Chemicals Co., Ltd.

A specific organic aluminum compound of Formula (I) in which n is from 1 to 3 can be prepared by mixing the above aluminum trialkoxide with a compound having a specific structure with two carbonyl groups.

When aluminum trialkoxide and the compound having a specific structure with two carbonyl groups are mixed, at least some of alkoxide groups in the aluminum trialkoxide is substituted with the compound having a specific structure with two carbonyl groups to form an aluminum alkoxylate structure. In this case, there may be a solvent as needed, and thermal treatment, addition of a catalyst or the like may be conducted. By replacing at least a portion of the aluminum alkoxide structure with aluminum chelate structure, stability of the specific organic aluminum compound against hydrolysis or polymerization reaction is improved, so storage stability of the composition for forming a passivation layer is improved.

A compound having a specific structure with two carbonyl groups is preferably at least one selected from the group consisting of a β-diketone compound, a β-keto ester compound, the malonic acid diester, from the viewpoint of storage stability.

Examples of a β-diketone compound typically include acetylacetone, 3-methyl-2,4-pentanedione, 2,3-pentanedione, 3-ethyl-2,4-pentanedione, 3-butyl-2,4-pentanedione, 2,2,6,6-tetramethyl-3,5-heptanedione, 2,6-dimethyl-3,5-heptanedione, 6-methyl-2,4-heptanedione.

Examples of a β-keto ester compound typically include methyl acetoacetate, ethyl acetoacetate, propyl acetoacetate, isobutyl acetoacetate, butyl acetoacetate, t- butyl acetoacetate, pentyl acetoacetate, isopentyl acetoacetate, hexyl acetoacetate, n-octyl acetoacetate, heptyl acetoacetate, 3-pentyl acetoacetate, ethyl 2-acetylheptanoate, ethyl 2-butylacetoacetate, ethyl 4,4-dimethyl-3-oxovalerate, ethyl 4-methyl-3-oxovalerate, ethyl 2-ethylacetoacetate, ethyl hexylacetoacetate, methyl 4-methyl-3-oxovalerate, isopropyl acetoacetate, ethyl 3-oxohexanoate, ethyl 3-oxovalerate, methyl 3-oxovalerate, methyl 3-oxohexanoate, ethyl 2-methylacetoacetate, ethyl 3-oxoheptanoate, methyl 3-oxoheptanoate, methyl 4,4-dimethyl-3-oxovalerate.

Examples of malonate diester typically include dimethyl malonate, diethyl malonate, dipropyl malonate, diisopropyl malonate, dibutyl malonate, di-t-butyl malonate, dihexyl malonate, t-butylethyl malonate, diethyl methylmalonate, diethyl ethylmalonate, diethyl isopropylmalonate, diethyl butylmalonate, diethyl sec-butylmalonate, diethyl isobutylmalonate, diethy 1-methylbutylmalonate.

When a specific organic aluminum compound has aluminum chelate structure, the number of aluminum chelate structure is not particularly limited so long as it is within the range from 1 to 3. Especially, from the viewpoint of storage stability, it is preferably 1 or 3, and from the viewpoint of solubility, it is preferably 1. The number of the aluminum chelate can be controlled, for example, by properly regulating a mixed ratio of aluminum trialkoxide and a compound having a specific structure with two carbonyl groups. A compound with a desired structure may be appropriately selected from commercially available aluminum chelate compounds.

Among organic aluminum compounds represented by Formula (I), it is preferable to use at least one selected typically from the group consisting of aluminum ethyl acetoacetate diisopropylate and triisopropoxy aluminum, and it is more preferable to use aluminum ethyl acetoacetate diisopropylate, from the viewpoint of passivation effect and compatibility with solvent to be added as needed

The presence of an aluminum chelate structure in the specific organic aluminum compound can be confirmed by the conventionally used analysis method. Specifically, it is confirmed by using an infrared spectroscopy spectrum, a nuclear magnetic resonance spectrum, a melting point or the like.

A specific organic aluminum compound may be liquid or solid, and is not particularly limited. From the viewpoint of passivation effect and storage stability, a specific organic aluminum compound is preferably one having favorable stability at ambient temperature (25°C), and, when a solvent is used, favorable solubility or dispersibility in the solvent. By using the specific organic aluminum compound, homogeneity of the passivation layer formed is more improved, and a desired passivation effect tends to be obtained stably.

The content ratio of the specific organic aluminum compound contained in the composition for forming a passivation layer can be selected appropriately as needed. For example, the content ratio of the specific organic aluminum compound in a composition for forming a passivation layer may be from 0.1 % by mass to 70% by mass, preferably from 0.5% by mass to 60% by mass, more preferably from 1% by mass to 50% by mass, and still more preferably from 1.2% by mass to 30% by mass, from the viewpoint of storage stability and passivation effect.

A content of a specific organic aluminum compound to be applied to a semiconductor substrate is from 0.01 mg to 1 mg per 1 square cm, preferably from 0.013 mg to 0.7 mg, more preferably from 0.015 mg to 0.6 mg, and still more preferably from 0.02 mg to 0.5 mg, from the viewpoint of vaporizing a compound of Formula (II) and passivation effect.

(Organic compound represented by Formula (II))

A composition for forming a passivation layer contains an organic compound represented by Formula (II) (a compound of Formula (II)).

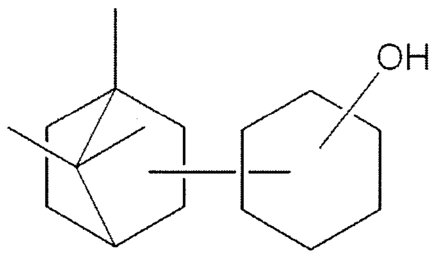

(II)

A composition for forming a passivation layer can improve a passivation effect by containing an organic compound represented by Formula (II) and can inhibit generation of a black residue after the thermal treatment (calcination). For example, an organic compound represented by Formula (II) includes isobornyl cyclohexanol.

As isobornyl cyclohexanol, "TERUSOLV MTPH" (NIPPON TERPENE CHEMICALS, INC., trade name) is commercially available. Isobornyl cyclohexanol has a boiling point as high as from 308°C to 318°C, and for removal from a composition layer, it can be eliminated by vaporizing it upon heating without defatting treatment by thermal treatment (calcination) like a resin. Therefore, during a drying process after application onto a semiconductor substrate, most of a solvent as needed and isobornyl cyclohexanol contained in a composition for forming a passivation layer can be removed and generation of a black residue after thermal treatment (calcination) can be inhibited.

A passivation effect is thought to become higher by combining an organic aluminum compound represented by Formula (I) and an organic compound represented by Formula (II). The mechanism of this is considered to be as follows.

When a composition for forming a passivation layer containing a binder resins is used, the binder resin is removed by a defatting process, resulting in tendency of generating a void in the passivation layer or inhomogeneously

forming a passivation layer. In contrast, an organic compound represented by Formula (II) can be eliminated by vaporization upon heating without a defatting process. Therefore, in the passivation layer formed using a composition for forming a passivation layer of the present invention obtained by combining an organic aluminum compound represented by Formula (I) and an organic compound represented by Formula (II), the development of the void is inhibited, and the uniformity of the passivation layer is enhanced, and hence a passivation effect by an electric field effect is considered to be sufficient.

The content ratio of an organic compound represented by Formula (II) included in the composition for forming a passivation layer is preferably from 30% by mass to 99.9% by mass, more preferably from 40% by mass to 95% by mass, and still more preferably from 60% by mass to 90% by mass.

(Solvent)

A composition for forming a passivation layer preferably contains a solvent. Containing a solvent in a composition for forming a passivation layer facilitates adjustment of viscosity, further improves applicability, and tends to form a more homogeneous passivation layer. A solvent is not particularly limited, and can be appropriately selected as needed. Among them, a solvent which can provide a homogeneous solution with a specific aluminum compound and in which a compound of Formula (II) dissolved is preferable, and which contains at least one organic solvent is more preferred.

Examples of a solvent typically include; ketone solvents such as acetone, methyl ethyl ketone, methyl-n-propyl ketones, methyl isopropyl ketone, methyl-n-butyl ketones, methyl isobutyl ketone, methyl-n-pentyl ketones, methyl-n-hexyl ketones, diethyl ketone, dipropyl ketones, diisobutyl ketones, trimethyl nonanone, cyclohexanone, cyclopentanone, methylcyclohexanone, 2,4-pentanedione, acetonyl-acetone; ether solvents such as diethyl ether, methyl ethyl ether, methyl-n-propyl ether, diisopropyl ether, tetrahydrofuran, methyl tetrahydrofuran, dioxane, dimethyl dioxane, ethylene glycol dimethyl ether, ethylene glycol diethyl ether, ethylene glycol di-n-propyl ether, ethylene glycol dibutyl ether, diethyleneglycol dimethylether, diethylene glycol diethyl ether, diethylene glycol methyl ethyl ether, diethylene glycol methyl-n-propyl ether, diethylene glycol methyl-n-butyl ether, diethylene glycol di-n-propyl ether, diethylene glycol di-n-butyl ether, diethylene glycol methyl-n-hexyl ether, triethylene glycol dimethyl ether, triethylene glycol diethyl ether, triethylene glycol methyl ethyl ether, triethylene glycol methyl-n-butyl ether, triethylene glycol di-n-butyl ether, triethylene glycol methyl-n-hexyl ether, tetraethylene glycol dimethyl ether, tetraethylene glycol diethyl ether, tetraethylene glycol methylethyl ether, tetraethylene glycol methyl-n-butyl ether, tetraethylene glycol di-n-butyl ether, tetraethylene glycol methyl-n-hexyl ether, tetraethylene glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methylethyl ether, dipropylene glycol methyl-n-butyl ether, dipropylene glycol di-n-propyl ether, dipropylene glycol di-n-butyl ether, dipropylene glycol methyl-n-hexyl ether, tripropylene glycol dimethyl ether, tripropylene glycol diethyl ether, tripropylene glycol methylethyl ether, tripropylene glycol methyl-n-butyl ether, tripropylene glycol di-n-butyl ether, tripropylene glycol methyl-n-hexyl ether, tetrapropylene glycol dimethyl ether, tetrapropylene glycol diethyl ether, tetrapropylene glycol methylethyl ether, tetrapropylene glycol methyl-n-butyl ether, tetrapropylene glycol di-n-butyl ether, tetrapropylene glycol methyl-n-hexyl ether, the tetrapropylene glycol di-n-butyl ether; ester solvents such as methyl acetate, ethyl acetate, n-propyl acetate, isopropyl acetate, n-butyl acetate, isobutyl acetate, see-butyl acetate, n-pentyl acetate, sec-pentyl acetate, 3-methoxybutyl acetate, methylpentyl acetate, 2-ethylbutyl acetate, 2-ethylhexyl acetate, 2-(2-butoxyethoxy)ethyl acetate, benzyl acetate, cyclohexyl acetate, methylcyclohexyl acetate, nonyl acetate, methyl acetoacetate, ethyl acetoacetate, diethylene glycol methyl ether acetate, diethylene glycol monoethyl ether acetate, dipropylene glycol methyl ether acetate, dipropylene glycol ethyl ether acetate, glycol diacetate, methoxytriethylene glycol acetate, ethyl propionate, n-butyl propionate, isoamyl propionate, diethyl oxalate, di-n-butyl oxalate, methyl lactate, ethyl lactate, n-butyl lactate, n-amyl lactate, ethylene glycol methyl ether propionate, ethylene glycol ethyl ether propionate, ethylene glycol methyl ether acetate, ethylene glycol ethyl ether acetate, propylene glycol methyl ether acetate, propylene glycol ethyl ether acetate, propylene glycol propyl ether acetate, $\gamma$-butyrolactone, $\gamma$-valerolactone; aprotic polar solvents such as acetonitrile, N-methylpyrrolidinone, N-ethylpyrrolidinone, N-propylpyrrolidinone, N-butylpyrrolidinone, N-hexylpyrrolidinone, N-cyclohexylpyrrolidinone, N,N-dimethylformamide, N,N-dimethylacetamide, dimethylsulfoxide; hydrophobic organic solvents such as methylene chloride, chloroform, dichloroethane, benzene, toluene, xylene, hexane, octane, ethylbenzene, 2-ethyl hexanoic acid, methyl isobutyl ketone, methyl ethyl ketone; alcohol solvents such as methanol, ethanol, n-propanol, isopropanol, n-butanol, isobutanol, sec-butanol, t-butanol, n-pentanol, isopentanol, 2-methyl butanol, sec-pentanol, t-pentanol, 3-methoxybutanol, n-hexanol, 2-methyl pentanol, sec-hexanol, 2-ethyl butanol, sec-heptanol, n-octanol, 2-ethylhexanol, sec-octanol, n-nonyl alcohol, n-decanol, sec-undecyl alcohol, trimethyl nonyl alcohol, sec-tetradecyl alcohol, sec-heptadecyl alcohol, cyclohexanol, methylcyclohexanol, benzyl alcohol, ethylene glycol, 1,2-propylene glycol, 1,3-butylene glycol, diethylene glycol, dipropylene glycol, triethylene glycol, tripropylene glycol; glycol monoether solvents such as ethylene glycol monomethyl ether, ethylene glycol monoethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxytriglycol, tetraethylene glycol mono-n-butyl

ether, propylene glycol monomethyl ether, dipropylene glycol monomethyl ether, dipropylene glycol monoethyl ether, tripropylene glycol monomethyl ether; terpene solvents such as terpinene (α-terpinene), terpineol (α-terpineol), myrcene, alloocimene, limonene, dipentene, pinene (α-pinene, β-pinene or the like), carvone, ocimene, phellandrene; water. These solvents may be used alone or as a combination of more than one thereof.

Especially, from the viewpoint of applicability to a semiconductor substrate and pattern forming ability, a solvent preferably contains at least one selected from the group consisting of terpene solvent, ester solvent and the alcohol solvent, and more preferably contains at least one selected from the group consisting of terpene solvent.

When composition for forming a passivation layer includes a solvent, the content ratio of the solvent in composition for forming a passivation layer is determined considering applicability, pattern forming ability and storage stability. For example, from the viewpoint of applicability and pattern forming ability of the composition for forming a passivation layer, the content ratio of the solvent is preferably from 5% by mass to 98% by mass, and more preferably from 10% by mass to 95% by mass in a composition for forming a passivation layer.

(Other additives)

The composition for forming a passivation layer may contain an acidic compound or a basic compound. When the composition for forming a passivation layer contains an acidic compound or a basic compound, from the viewpoint of storage stability, the content ratio of an acidic compound and the basic compound is preferably 1% by mass or less, and more preferably 0.1 % by mass or less in the composition for forming a passivation layer, respectively.

An acidic compound can include Broensted acid and Lewis acid. Specifically, an inorganic acid such as hydrochloric acid and the nitric acid, and an organic acid such as acetic acid can be included. A basic compound can include a Broensted base and a Lewis base, and particularly, inorganic bases such as alkali metal hydroxide and alkaline earth metals hydroxide, organic bases such as trialkylamine and pyridine.

It is preferable that a composition for forming a passivation layer substantially contains no resin binders such as ethyl cellulose (e.g., not more than 3% by mass, preferably not more than 2% by mass, more preferably not more than1.5% by mass). Generation of a black residue can be inhibited by containing substantially no resin binder.

(Physical property)

Viscosity of a composition for forming a passivation layer is not limited and can be appropriately selected depending on the method of application on a semiconductor substrate. For example, viscosity of a composition for forming a passivation layer can be from 0.01 Pa.s to 10000 Pa.s. From the viewpoint of pattern formability, viscosity of a composition for forming a passivation layer is preferably from 0.1 Pa.s to 1000 Pa.s. The viscosity is measured at 25.0°C, at a shear rate of 1.0 $s^{-1}$ using a rotational shear viscometer.

The shear viscosity of a composition for forming a passivation layer is not particularly limited, and a composition for forming a passivation layer preferably has thixotropic property. Especially, from the viewpoint of pattern formability, a thixotropic ratio ($\eta 1/\eta 2$), which is obtained by dividing shear viscosity $\eta 1$ at shear rate 10 $s^{-1}$ by shear viscosity $\eta 2$ at shear rate 1000 $s^{-1}$, is preferably from 1.05 to 100, more preferably from 1.1 to 50, and still more preferably from 1.5 to 10. The shear viscosity is measured at temperature 25.0°C using a rotational shear viscometer equipped with a cone plate (diameter, 50 mm; cone angle, 1°).

In addition, an ingredient included in the composition for forming a passivation layer and content of the individual ingredient can be confirmed using thermal analysis such as thermogravity/differential thermal analysis (TG/DTA), nuclear magnetic resonance (NMR), spectrum analyses such as the infrared spectroscopy (IR), chromatograph analyses such as high performance liquid chromatography (HPLC), gel permeation chromatography (GPC) and elemental analysis.

(Method of producing composition for forming passivation layer)

A method of producing a composition for forming a passivation layer is not particularly limited. For example, it can be produced by mixing a specific organic aluminum compound, a compound of Formula (II), and a solvent to be included as needed according to the conventionally used mixing method. It may also be produced by dissolving a compound of Formula (II) in a solvent, and then mixing the resultant with a specific organic aluminum compound.

In addition, the specific organic aluminum compound may be prepared by mixing aluminum alkoxide and the compound which can form a chelate with aluminum. In this case, a solvent may be used, and thermal treatment may be conducted, as needed. Thus prepared specific organic aluminum compound may be mixed with a solution containing a compound of Formula (II) or (III) to produce a composition for forming a passivation layer.

<Semiconductor substrate with passivation layer>

The semiconductor substrate with a passivation layer of the present invention includes: a semiconductor substrate; and a passivation layer, which is provided on an entire or partial surface of the semiconductor substrate, and which is a resultant of subjecting the composition for forming a passivation layer to a thermal treatment.

A semiconductor substrate with a passivation layer shows an excellent passivation effect by having the passivation layer that is a resultant of thermal treatment (a resultant layer of calcination) of the above composition for forming a passivation layer.

A semiconductor substrate is not particularly limited, and can be appropriately selected from those conventionally used depending on a purpose. A semiconductor substrate includes those obtained by doping (diffusing) p-type impurity or n-type impurity into silicon, germanium or the like. Especially, a silicon substrate is preferred. A semiconductor substrate may be a p-type semiconductor substrate or an n-type semiconductor substrate. Especially, a semiconductor substrate, in which a surface on which a passivation layer is formed is a p-type layer, is preferred. A p-type layer on a semiconductor substrate may be a p-type layer derived from a p-type semiconductor substrate, or one formed on an n-type semiconductor substrate or a p-type semiconductor substrate as a p-type diffusion layer or a $p^+$-type diffusion layer.

The thickness of a semiconductor substrate is not particularly limited, and appropriately selected depending on a purpose. For example, thickness of a semiconductor substrate is from 50 $\mu$m to 1,000 $\mu$m, and preferably from 75 $\mu$m to 750 $\mu$m.

The thickness of the passivation layer formed on a semiconductor substrate is not particularly limited, and can be appropriately selected depending on a purpose. For example, a thickness of a passivation layer is preferably from 1 nm to 1,000 nm, more preferably from 2 nm to 800 nm, and still more preferably from 3 nm to 500 nm. Thickness of a passivation layer can be measured with an interference type film thickness meter.

The semiconductor substrate with a passivation layer can be applied to a photovoltaic cell element, a light emitting diode element or the like. For example, it can be applied to a photovoltaic cell element to obtain a photovoltaic cell element excellent in conversion efficiency.

<Method of producing semiconductor substrate with passivation layer>

A method of producing a semiconductor substrate with a passivation layer of the present invention includes: applying the composition for forming the passivation layer onto an entire or partial surface of a semiconductor substrate to form a composition layer; and subjecting the composition layer to a thermal treatment (calcination) to form a passivation layer. The above producing method may further include other processes as needed.

By using the composition for forming a passivation layer, a passivation layer having an excellent passivation effect is formed into a desired shape by a simple method.

The method of producing a semiconductor substrate with a passivation layer preferably further includes applying an aqueous alkaline solution onto the semiconductor substrate before forming the composition layer. In other words, a surface of a semiconductor substrate is preferably washed with an aqueous alkaline solution before application of a composition for forming a passivation layer on a semiconductor substrate. Washing with an aqueous alkaline solution can remove any organics, particles or the like which exist on a surface of a semiconductor substrate, thereby enhancing passivation effect. A method of washing with an alkaline aqueous solution includes the well-known RCA washing. For example, a semiconductor substrate is soaked into a mixture of the ammonium hydroxide - hydrogen peroxide water, then treated at from 60°C to 80°C to remove organics and particle, and thus wash the semiconductor substrate. Washing time is preferably between 10 seconds and 10 minutes, more preferably between 30 seconds and 5 minutes.

In RCA washing, a semiconductor substrate is at first placed in an aqueous dilute hydrofluoric acid solution (HF). This operation, when a semiconductor substrate is a silicon substrate, dissolves a top thin Si oxide film and, removes many foreign bodies attached thereon. In addition, organics and particles are removed with a mixed solution of aqueous ammonia ($NH_4OH$) - hydrogen peroxide ($H_2O_2$), and subsequently metals are removed with hydrochloric acid (HCl) and hydrogen peroxide ($H_2O_2$). Finally, work-up with ultrapure water may be conducted.

A method of forming a composition layer by applying a composition for forming a passivation layer onto a semiconductor substrate is not particularly limited. For example, a method of applying a composition for forming a passivation layer on a semiconductor substrate using a well-known application method is included. Specific examples thereof include soaking, printing, spin coating, brushing, spraying, doctor blading, roll coater, and ink-jet method.

The amount of a composition for forming a passivation layer to be applied may be appropriately selected depending on a purpose. For example, a thickness of the formed passivation layer can be adjusted to the desired one as described below.

A composition layer formed of a composition for forming a passivation layer is subjected to thermal treatment (calcination) to form a thermally-treated (calcined) resultant layer derived from the composition layer, thereby forming a passivation layer on a semiconductor substrate. Condition for thermal treatment (calcination) of a composition layer

is not particularly limited so long as a specific organic aluminum compound contained in the composition layer can be converted into aluminum oxide ($Al_2O_3$), which is a thermally-treated (calcined) resultant of the compound. Especially, a condition for thermal treatment (calcination) which enables formation of amorphous $Al_2O_3$ layer without a specific crystalline structure is preferred. When a passivation layer is composed of an amorphous $Al_2O_3$ layer, a negative charge can be imparted to the passivation layer more effectively, and more excellent passivation effect can be obtained. Specifically, thermal treatment temperature is preferably from 400°C to 900°C, and more preferably from 450°C to 800°C. Thermal treatment time is appropriately selected depending on thermal treatment (calcination) temperature or the like, and is preferably set to 0.1 hours to 10 hours, and more preferably 0.1 hours to 5 hours.

Thickness of a passivation layer prepared by a method of producing a semiconductor substrate with a passivation layer is not particularly limited, and can be appropriately selected depending on a purpose. For example, an average thickness of a passivation layer is preferably from 1 nm to 1,000 nm, more preferably from 2 nm to 800 nm, and still more preferably from 3 nm to 500 nm.

The average thickness of the formed passivation layer is determined by measuring thickness at 3 points using a probe type process and surface shape profiler (e.g., Ambios Ltd.), an interference type film thickness meter (e.g., FILMETRICS CORPORATION) by a routine method, and calculating as an arithmetic average.

The method of producing a semiconductor substrate with a passivation layer may further include drying treatment of a composition layer formed from a composition for forming a passivation layer, after applying a composition for forming a passivation layer, and before forming a passivation layer by thermal treatment (calcination). The drying treatment of a composition layer enables formation of a passivation layer having more homogeneous passivation effect.

The drying treatment of a composition layer is not particularly limited so long as at least a portion of a solvent contained as needed in the composition for forming a passivation layer may be removed. The drying treatment is a thermal treatment at the temperature from 30°C to 250°C for 1 minute to 60 minutes, and preferably at the temperature from 40°C to 240°C for 3 minutes to 40 minutes. Also, the drying treatment may be conducted at ambient pressure or under reduced pressure.

<Photovoltaic cell element>

The photovoltaic cell element of the present invention includes: a semiconductor substrate composed of a p-type layer and an n-type layer connected by a p-n junction; a passivation layer, which is provided on an entire or partial surface of the semiconductor substrate, and which is a resultant of subjecting the composition for forming a passivation layer to a thermal treatment; and an electrode provided on one or more layers selected from the group consisting of the p-type layer and the n-type layer. A photovoltaic cell element may further have other component as needed.

The photovoltaic cell element is excellent in conversion efficiency by having a passivation layer formed of a composition for forming a passivation layer of the present invention.

A semiconductor substrate to which is applied a composition for forming a passivation layer is not particularly limited, and appropriately selected from those conventionally used depending on a purpose. As a semiconductor substrate, any one described for a substrate with a passivation layer can be used, and those preferably used is also as described above. A surface to which a passivation is applied may be a p-type layer or an n-type layer. Especially, a p-type layer is preferred from the viewpoint of conversion efficiency. A p-type layer on the above semiconductor substrate may be a p-type layer derived from a p-type semiconductor substrate or those formed on an n-type semiconductor substrate or a p-type semiconductor substrate as a p-type diffusion layer or a $p^+$-type diffusion layer.

Thickness of the passivation layer formed on a semiconductor substrate is not particularly limited, and can be appropriately selected depending on a purpose. For example, the average thickness of a passivation layer is preferably from 1 nm to 1,000 nm, preferably from 2 nm to 800 nm, and more preferably from 3 nm to 500 nm.

<Method of producing photovoltaic cell element>

A method of producing a photovoltaic cell element includes: applying a composition for forming a passivation layer onto at least a portion of a surface having an electrode of a semiconductor substrate, the semiconductor substrate including a p-n junction composed of a p-type layer and an n-type layer that are connected, and the electrode on one or more layers selected from the group consisting of the p-type layer and the n-type layer; and subjecting the composition layer to a thermal treatment to form a passivation layer. The method of producing a photovoltaic cell element may further includes other processes as needed.

By using a composition for forming a passivation layer of the present invention, a photovoltaic cell element excellent in conversion efficiency which includes a passivation layer having excellent passivation effect can be produced by a simple method.. Furthermore, a passivation layer can be formed in a desired shape on a semiconductor substrate on which an electrode has been formed, providing excellent productivity of a photovoltaic cell element.

A semiconductor substrate with a p-n junction, in which an electrode is placed on at least one of a p-type layer

and an n-type layer, can be produced by a conventionally used method. For example, it is produced by applying a paste for forming an electrode such as a silver paste and an aluminum paste, followed by thermal treatment (calcination) as needed.

The surface on which a passivation layer is applied may be a p-type layer or an n-type layer. Especially, a p-type layer is preferred from the viewpoint of conversion efficiency.

The details of a method of forming the passivation layer using a composition for forming a passivation layer and a preferable aspect thereof are similar to the above-described method of producing a semiconductor substrate.

Thickness of a passivation layer formed on a semiconductor substrate is not particularly limited, and can be appropriately selected depending on a purpose. For example, an average thickness of a passivation layer is preferably from 1 nm to 1,000 nm, from 2 nm to 800 nm, and still more preferably from 3 nm to 500 nm.

Embodiments of the present invention will be illustrated referring to appended drawings.

Fig. 1 is a process chart which schematically shows an example of a method of producing a photovoltaic cell element with a passivation layer according to an embodiment of the present invention as a cross section. However, this process chart does not limit the present invention at all.

As shown in Fig. 1 (a), a p-type semiconductor substrate 1 has an $n^+$-type diffusion layer 2 formed near the surface, and an anti-reflection layer 3 formed on the top surface. Anti-reflection film 3 includes a silicon nitride film and a titanium oxide film. A surface protective film (not shown) such as silicon oxide may be present between the anti-reflection film 3 and the p-type semiconductor substrate 1. A passivation layer according to the present invention may be used as a top protective film.

Subsequently, as shown in Fig. 1 (b), a material for forming a back contact electrode, such as an aluminum electrode paste, is applied on a portion of a back surface, and subjected to thermal treatment (calcination) to form a back contact electrode 5, and an aluminum atom is allowed to diffuse into a p-type semiconductor substrate 1 to form a $p^+$-type diffusion layer 4.

Subsequently, as shown in Fig. 1 (c), a paste for forming an electrode is applied on a light receiving surface, and after that subjected to thermal treatment (calcination) to form a light receiving surface electrode 7. As shown in Fig. 1 (c), by using a paste containing a glass powder having a fire-through property as a paste for forming an electrode, a light-receiving surface electrode 7 is formed, which electrode penetrates through an anti-reflection film 3 and projects on the $n^+$-type diffusion layer 2, to obtain ohmic contact.

Subsequently, as shown in Fig. 1 (d), a composition for forming a passivation layer is applied in the region on the back surface of the p-type layer other than the region in which an back contact electrode 5 is formed by screen-printing to form a composition layer. The composition layer formed on the p-type layer is subjected to thermal treatment (calcination) to form a passivation layer 6. A passivation layer 6 formed of a composition for forming a passivation layer of the present invention is formed on a back surface of a p-type layer, to produce a photovoltaic cell element excellent in power generation efficiency.

In a photovoltaic cell element produced by a producing method including a process shown in Fig. 1, a back contact electrode made of aluminum or the like may be prepared as a point contact structure to reduce warpage of substrate. Furthermore, a passivation layer can be formed with excellent productivity at a specific position (specifically, on the p-type layer excluding a region in which an electrode is formed) by using the above composition for forming a passivation layer.

Although a method for forming a passivation layer only on a back surface is shown in Fig. 1 (d), a composition for forming a passivation layer is also applied to the side surface, in addition to a back surface, of the p-type semiconductor substrate 1, and subjected to thermal treatment (calcination), to form a passivation layer 6 on a side surface (edge) of the p-type semiconductor substrate 1 (not shown). Thus, a photovoltaic cell element excellent in power generation efficiency can be produced.

Furthermore, a passivation layer may be formed by applying a composition for forming a passivation layer of the present invention only to a side surface without forming a passivation layer on a back surface, and subjected to thermal treatment (calcination). A composition for forming a passivation layer of the present invention has especially great effect when applied to an area having many crystal defects such as a side surface.

Although an embodiment, in which a passivation layer is formed after forming an electrode, is illustrated in Fig. 1, an electrode such as aluminum may be further formed in a desired region, for example, by vapor deposition after the passivation layer is formed.

Fig. 2 is a process chart as a cross sectional view schematically showing another example of a method of producing a photovoltaic cell element having a passivation layer according to an embodiment of the present invention. Specifically, Fig. 2 illustrates as a cross section a process chart including forming a $p^+$-type diffusing layer by using an aluminum electrode paste or a composition for forming a p-type diffusion layer which can form a $p^+$-type diffusion layer by thermal diffusion treatment, and then removing a resultant of thermal treatment of the aluminum electrode paste or a resultant of thermal treatment of composition for forming a p-type diffusion layer. Examples of a composition for a p-type diffusion layer formation can include, for example, an acceptor element containing substance and a glass component.

As shown in Fig. 2 (a), a p-type semiconductor substrate 1 has an $n^+$-type diffusion layer 2 formed near the surface and an anti-reflection film 3 formed on the surface. Examples of an anti-reflection film 3 include a silicon nitride film and a titanium oxide film.

Subsequently, a composition for forming a p-type diffusion layer is applied onto a partial portion of a back surface, and then thermally-treated to form a $p^+$-type diffusion layer 4, as shown in Fig. 2 (b). The resultant of thermal treatment 8 of a composition for a p-type diffusion layer formation is formed on a $p^+$-type diffusion layer 4.

In this case, an aluminum electrode paste may be used in place of a composition for forming a p-type diffusion layer. When an aluminum electrode paste is used, an aluminum electrode 8 is formed on a $p^+$-type diffusion layer 4.

Subsequently, resultant of thermal treatment 8 of a composition for forming a $p^+$-type diffusion layer formed or aluminum electrode 8 on a $p^+$-type diffusion layer 4 is removed by technique such as the etching, as shown in Fig. 2 (c).

Subsequently, as shown in Fig. 2 (d), a paste for forming an electrode is selectively applied on a partial portion of a light receiving surface (front surface) and a back surface, and then thermally-treated to form a light receiving surface electrode 7 on the light receiving surface (front surface) and a back contact electrode 5 on the back surface, respectively. When glass powder having fire-through property is used as a paste for forming an electrode to be applied onto a light receiving surface, a light receiving surface electrode 7, which penetrates through an anti-reflection film 3 and project on an $n^+$-type diffusion layer 2, is formed as shown in Fig. 2 (c), providing ohmic contact.

Because a $p^+$-type diffusion layer 4 has been already formed in the region where back contact electrode is to be formed, a paste for forming an electrodes which forms a back contact electrode 5 is not limited to an aluminum electrode paste, and a paste for an electrode which can form an electrode having low resistance such as a silver electrode paste may be used. Power generation efficiency can be thereby further enhanced.

A composition for forming a passivation layer is applied onto a region of the back surface of a p-type layer excluding the region in which a back contact electrode 5 is formed, thereby forming a composition layer, as shown in Fig. 2 (e). Application can be carried out by a method such as screen-printing. A composition layer formed on a $p^+$-type diffusion layer 4 is subjected to thermal treatment (calcination) to form a passivation layer 6. A passivation layer 6 formed of a composition for forming a passivation layer of the present invention may be formed on a p-type layer of the back surface, thereby producing a photovoltaic cell element having excellent power generation efficiency.

Although a method of forming a passivation layer on a back surface area alone is shown in Fig. 2 (e), a material for forming a passivation layer may be applied on side surface, in addition to a back surface, of a p-type semiconductor substrate 1, and subjected thermal treatment (calcination), to further form a passivation layer on a side surface (edge) of the p-type semiconductor substrate 1 (not shown). A photovoltaic cell element which is excellent in power generation efficiency can be thereby produced.

Furthermore, a composition for forming a passivation layer of the present invention may be applied on a side surface alone without forming a passivation layer on a back surface, then subjected to thermal treatment (calcination) to form a passivation layer. A composition for forming a passivation layer of the present invention has especially great effect when it is applied to an area having many crystal defects such as a side surface.

An embodiment in which a passivation layer is formed after an electrode is formed is illustrated in Fig. 2, but an electrode such as aluminum may be formed in a desired region by vapor deposition or the like after formation of a passivation layer.

Although the case using a p-type semiconductor substrate in which an $n^+$-type diffusion layer is formed on a light receiving surface is illustrated in the embodiment described above, a photovoltaic cell element may be manufactured in the same manner using an n-type semiconductor substrate in which a $p^+$-type diffusion layer is formed on its light receiving surface. In this case, an $n^+$-type diffusion layer should be formed on a back surface.

Furthermore, a composition for forming a passivation layer can be used in forming a passivation layer 6 on a light receiving surface or a back surface of a back contact electrode type photovoltaic cell element in which an electrode is located only on its back surface as shown in Fig. 3.

As schematically shown in Fig. 3 as a cross sectional view, an $n^+$-type diffusion layer 2 is formed near the surface, and a passivation layer 6 and anti-reflection film 3 are formed on the surface of the $n^+$-type diffusion layer 2, on a light receiving surface of a p-type semiconductor substrate 1. Examples of an anti-reflection film 3 include a silicon nitride film and a titanium oxide film. A passivation layer 6 is formed by applying a composition for forming a passivation layer of the present invention and subjecting it to thermal treatment (calcination.

On a back surface of a p-type semiconductor substrate 1, a back contact electrode 5 is provided on a $p^+$-type diffusion layer 4 and on an $n^+$-type diffusion layer 2, respectively, and a passivation layer 6 is provided in a region where a back surface electrode is not formed.

A $p^+$-type diffusion layer 4 can be formed by applying a composition for forming a p-type diffusion layer or an aluminum electrode paste to a desired region, and then subjected to thermal treatment (calcination), as described above. An $n^+$-type diffusion layer 2 can be formed, for example, by applying a composition for forming an n-type diffusion layer which can form an $n^+$-type diffusion layer upon thermal diffusion treatment, and thereafter conducting a thermal treatment.

Examples of a composition for forming an n-type diffusion layer formation can include a composition including

a donor element-containing material and a glass component.

Back contact electrode 5 which is provided on a $p^+$-type diffusion layer 4 and an $n^+$-type diffusion layer 2, respectively, can be formed using a paste conventionally used for formation of an electrode such as a silver electrode paste.

A back contact electrode 5 provided on a p-type diffusion layer 4 may be an aluminum electrode formed with a $p^+$-type diffusion layer 4 together using an aluminum electrode paste.

A passivation layer 6 which is provided on a back surface can be formed by applying a composition for forming a passivation layer in a region where a back contact electrode 5 is not provided, and then subjected to thermal treatment (calcination).

A passivation layer 6 may be formed not only on a back surface but also on a side surface of a p-type semiconductor substrate 1 (not shown).

A back contact electrode type photovoltaic cell element shown in Fig. 3 is excellent in power generation efficiency because it has no electrode on its light receiving surface. Furthermore, it is also excellent in conversion efficiency because a passivation layer is formed in the region on a back surface where an electrode is not formed.

Although an example using a p-type semiconductor substrate as a semiconductor substrate is shown above, a photovoltaic cell elements excellent in conversion efficiency can be produced using an n-type semiconductor substrate in the same manner as described above. A shape and the size of the photovoltaic cell element may not be particularly limited, and preferably conventionally a square, from 125 mm to 156 mm on a side.

<Photovoltaic cell>

A photovoltaic cell includes the photovoltaic cell element, and a wiring material provided on an electrode of the photovoltaic cell element. A photovoltaic cell is further composed of a plurality of photovoltaic cell elements connected through a wiring material such as a tab wire as needed, and may be further sealed with a sealant. A wiring material and a sealant material are not particularly limited, and those conventionally used in the art may be appropriately selected. The size of the photovoltaic cell is not particularly limited, and preferably conventionally from $0.5m^2$ to $3\ m^2$.

## EXAMPLES

The present invention is hereinafter specifically explained in examples, but the present invention is not limited thereto.

<Example 1>

(Preparation of composition for forming passivation layer 1)

2.90 g of ethyl acetoacetate aluminum diisopropylate (Kawaken Fine Chemicals Co., Ltd., a trade name: ALCH) as an organic aluminum compound represented by Formula (I), 13.33 of isobornyl cyclohexanol (Nippon Terpene Chemicals, Inc., a trade name: TERUSOLV MTPH) as an organic compound represented by Formula (II), and 3.18 g of terpineol as a solvent were mixed together to prepare a composition for forming a passivation layer 1. In the composition for forming a passivation layer 1, the content ratio of isobornyl cyclohexanol was 68.7% by mass, and the content ratio of the organic aluminum compound was 14.9% by mass.

(Thixotropic ratio)

A shear viscosity of a composition for forming a passivation layer 1 prepared above was measured under conditions of temperature at 25.0°C, shear rate of 10 $s^{-1}$ and 1,000 $s^{-1}$ immediately after preparation (within 12 hours), using a rotational viscometer (Anton Paar GmbH, MCR301) with a cone plate (diameter, 50 mm; cone angle, 1°).

A shear viscosity ($\eta 1$) at a shear rate of 10 $s^{-1}$ was 30 Pa.s, and a shear viscosity ($\eta 2$) at a shear rate of 1,000 $s^{-1}$ was 13.0 Pa.s. A thixotropic ratio ($\eta 1/\eta 2$) where shear viscosity was 10 $s^{-1}$ and 1,000 $s^{-1}$ was 2.3.

(Formation of passivation layer)

As a semiconductor substrate, a single-crystal p-type silicon substrate (SUMCO CORPORATION, 50 mm sq., thickness: 725 $\mu$m) having a mirror shape surface was used. A silicon substrate was immersed and washed at 70°C using RCA washings (KANTO CHEMICAL CO., INC., FrontierCleaner-A01) for five minutes whereby pre-treatment was conducted.

Subsequently, 42.4 mg of a composition for forming a passivation layer 1 obtained above was applied on a

pre-treated silicon substrate in a square, 4.5 cm on a side, using a screen-printing method. An aluminum compound in the applied composition for forming a passivation layer was 6.3 mg. Subsequently, drying treatment was conducted at 240°C for 5 minutes. Further, after thermal treatment at 800°C for 10 minutes, the resultant was allowed to cool at room temperature (25°C), thus a substrate for evaluation was prepared.

(Measurement of effective lifetime)

An effective lifetime (μs) of the substrate for evaluations obtained above was measured using a lifetime measuring assembly (SEMILAB JAPAN K.K., WT-2000PVN) at room temperature (25°C) according to a microwave reflection photoconductivity decay method. An effective lifetime of the region of the obtained substrate for evaluation, to which a composition for forming a passivation layer was applied, was 405 μs.

(Measurement of thickness of passivation layer)

The thickness of the passivation layer on the substrate for evaluations obtained above was measured using an interference type film thickness meter (FILMETRICS CORPORATION, F20). The thickness of the passivation layer was 314 nm.

(Observation of black residue)

A passivation layer on a substrate for evaluation obtained above was observed using a microscope for industrial inspection (OLYMPUS CORPORATION, MX-51). As a result, no black residue was observed.

<Example 2>

(Measurement of effective lifetime and thickness of passivation layer)

A passivation layer was formed and evaluated in the same manner as in Example 1, except that 30.7 mg of a composition for forming a passivation layer 1 was applied on a silicon substrate in a square, 4.5 cm on a side. The applied amount of the aluminum compound was 4.6 mg. The effective lifetime was 330 μs. The thickness of the passivation layer was 230 nm. No residues black was observed in a passivation layer on a substrate for evaluation.

<Example 3>

(Preparation of composition for forming passivation layer 2)

1.64 g of Ethyl acetoacetate aluminum diisopropylate, 12.02 g of isobornyl cyclohexanol, and 1.63 g of terpineol were mixed to prepare a composition for forming a passivation layer 2. The content ratio of isobornyl cyclohexanol in the composition for forming a passivation layer 2 was 78.6% by mass, and the content ratio of the organic aluminum compound was 10.7% by mass.

(Thixotropic ratio)

Shear viscosity of the composition for forming a passivation layer 2 prepared above was measured immediately after preparation (within 12 hours), using a rotational viscometer equipped with a cone plate (diameter, 50 mm, cone angle, 1°) under conditions at temperature of 25.0°C, at shear rate of 10 $s^{-1}$ and 1000 $s^{-1}$, respectively.

The shear viscosity at the shear rate of 10 $s^{-1}$ ($\eta 1$) was 26 Pa.s, and the shear viscosity at the shear rate of 1000 $s^{-1}$ ($\eta 2$) was 12.0 Pa.s. The thixotropic ratio of the shear viscosity of 10 $s^{-1}$ and 1,000 $s^{-1}$ ($\eta 1/\eta 2$) was 2.2.

(Measurement of effective lifetime and thickness of passivation layer)

A passivation layer was formed and evaluated in the same manner as in Example 1, except that 50.1 mg of a composition for forming a passivation layer 2 was applied on a pre-treated silicon substrate in a square, 4.5 cm on a side. The applied amount of the aluminum compound was 5.4 mg. The effective lifetime was 305 μs. The thickness of the passivation layer was 232 nm. No residues black was observed in a passivation layer on a substrate.

<Example 4>

(Measurement of effective lifetime and thickness of passivation layer)

A passivation layer was formed and evaluated in the same manner as in Example 1, except that 38.1 mg of a composition for forming a passivation layer 2 was applied on a pre-treated silicon substrate in a square, 4.5 cm on a side. The applied amount of the aluminum compound was 4.1 mg. The effective lifetime was 281 μs. The thickness of the passivation layer was 209 nm. No residues black was observed in a passivation layer on a substrate for evaluation.

<Example 5>

(Preparation of composition for forming passivation layer 3)

0.85 g of Ethyl acetoacetate aluminum diisopropylate, 12.69 g of isobornyl cyclohexanol, and 1.67 g of terpineol were mixed to prepare a composition for forming a passivation layer 3. The content ratio of isobornyl cyclohexanol in the composition for forming a passivation layer 3 was 83.4% by mass, and the content ratio of the organic aluminum compound was 5.6% by mass.

(Thixotropic ratio)

Shear viscosity of a composition for forming a passivation layer 3 prepared above was measured immediately after preparation (within 12 hours) using a rotational viscometer with a cone plate (diameter, 50 mm; cone angle, 1°) at a temperature of 25.0°C, at shear rate of 10 $s^{-1}$ and 1,000 $s^{-1}$, respectively.

The shear viscosity at the shear rate of 10 $s^{-1}$ ($\eta 1$) was 25 Pa.s, and the shear viscosity at a shear rate of 1,000 $s^{-1}$ ($\eta 2$) was 11 Pa.s. A thixotropic ratio of shear viscosity of 10 $s^{-1}$ and 1,000 $s^{-1}$ ($\eta 1/\eta 2$) was 2.3.

(Measurement of effective lifetime and thickness of passivation layer)

A passivation layer was formed and evaluated in the same manner as in Example 1, except that 48.0 mg of a composition for forming a passivation layer 3 was applied on a pre-treated silicon substrate in a square, 4.5 cm on a side. The applied amount of the aluminum compound was 2.7 mg. The effective lifetime was 310 μs. The thickness of the passivation layer was 139 nm. No residues black was observed in a passivation layer on a substrate for evaluation.

<Example 6>

(Measurement of effective lifetime and thickness of passivation layer)

A passivation layer was formed and evaluated in the same manner as in Example 1, except that 37.0 mg of a composition for forming a passivation layer 3 was applied on a pre-treated silicon substrate in a square, 4.5 cm on a side. The applied amount of the aluminum compound was 2.1 mg. The effective lifetime was 271 μs. The thickness of the passivation layer was 148 nm. No residues black was observed in a passivation layer on a substrate for evaluation.

<Example 7>

(Preparation of composition for forming passivation layer 4)

0.21 g of ethyl acetoacetate aluminum diisopropylate, 13.52 g of isobornyl cyclohexanol, and 1.87 g of terpineol were mixed to prepare a composition for forming a passivation layer 4. The content ratio of isobornyl cyclohexanol in the composition for forming a passivation layer 4 was 86.7% by mass, and the content ratio of the organic aluminum compound was 1.3% by mass.

(Thixotropic ratio)

Shear viscosity of a composition for forming a passivation layer 4 prepared above was measured immediately after preparation (within 12 hours) using a rotational viscometer with a cone plate (diameter, 50 mm; cone angle, 1°) at a temperature of 25.0°C, at shear rate of 10 $s^{-1}$ and 1,000 $s^{-1}$, respectively. The shear viscosity at the shear rate of 10 $s^{-1}$ ($\eta 1$) was 24 Pa.s, and the shear viscosity at a shear rate of 1,000 $s^{-1}$ ($\eta 2$) was 10 Pa.s. A thixotropic ratio of shear viscosity of 10 $s^{-1}$ and 1,000 $s^{-1}$ ($\eta 1/\eta 2$) was 2.4.

(Measurement of effective lifetime and thickness of passivation layer)

A passivation layer was formed and evaluated in the same manner as in Example 1, except that 54.5 mg of a composition for forming a passivation layer 4 was applied on a pre-treated silicon substrate in a square, 4.5 cm on a side. The applied amount of the aluminum compound was 0.7mg. The effective lifetime was 250 μs. The thickness of the passivation layer was 66 nm. No residues black was observed in a passivation layer on a substrate for evaluation.

<Example 8>

(Measurement of effective lifetime and thickness of passivation layer)

A passivation layer was formed and evaluated in the same manner as in Example 1, except that 37.6 mg of a composition for forming a passivation layer 4 was applied on a pre-treated silicon substrate in a square, 4.5 cm on a side. The applied amount of the aluminum compound was 0.5 mg. The effective lifetime was 264 μs. The thickness of the passivation layer was 80 nm. No residues black was observed in a passivation layer on a substrate for evaluation.

<Comparative Example 1>

(Preparation of composition for forming passivation layer 5)

100.0 g of ethyl cellulose and 900 g of terpineol were mixed, and then stirred at 150°C for an hour to prepare 10% by mass ethyl cellulose solution. Separately, 24.91 g of ethyl acetoacetate aluminum diisopropylate and 15.21 g of terpineol were mixed, then 25.05 g of 10% by mass ethyl cellulose solution was mixed to prepare a composition for forming a passivation layer 5 as clear and colorless solution. The content ratio of ethyl cellulose in the composition for forming a passivation layer 5 was 3.8% by mass, and the content ratio of the organic aluminum compound was 38.1% by mass.

(Thixotropic ratio)

Shear viscosity of a composition for forming a passivation layer 5 prepared above was measured immediately after preparation (within 12 hours) using a rotational viscometer with a cone plate (diameter, 50 mm; cone angle, 1°) at a temperature of 25.0°C, at shear rate of 10 $s^{-1}$ and 1,000 $s^{-1}$, respectively.

The shear viscosity at the shear rate of 10 $s^{-1}$ ($\eta 1$) was 45 Pa.s, and the shear viscosity at a shear rate of 1,000 $s^{-1}$ ($\eta 2$) was 1.2 Pa.s. A thixotropic ratio of shear viscosity of 10 $s^{-1}$ and 1,000 $s^{-1}$ ($\eta 1/\eta 2$) was 38.

(Measurement of effective lifetime and thickness of passivation layer)

42.3 mg of a composition for forming a passivation layer 5 was applied on a pre-treated silicon substrate in a square, 4.5 cm on a side, using screen printing method. The applied amount of the aluminum compound was 16.2 mg. Subsequently, drying treatment was conducted at 150°C for 3 minutes. Furthermore, thermal treatment (calcination) was conducted at 800°C for 10 minutes, then the resultant was allowed to cool at room temperature (25°C) to prepare a substrate for evaluation. The effective lifetime was 233 μs. The surface was covered with a black residue. The film thickness after the black residue was removed by blowing was 52 nm.

<Comparative Example 2>

(Preparation of composition for forming passivation layer 6)

30.12 g of ethyl acetoacetate aluminum diisopropylate and 15.00 g of terpineol were mixed, and then 50.10 g of 10% by mass ethyl cellulose solution of Comparative Example 1 was mixed to prepare a composition for forming a passivation layer 6 as a clear and colorless solution. The content ratio of ethyl cellulose in a composition for forming a passivation layer 6 was 5.3% by mass, and the content ratio of the organic aluminum compound was 31.6% by mass.

(Thixotropic ratio)

Shear viscosity of a composition for forming a passivation layer 6 prepared above was measured immediately after preparation (within 12 hours) using a rotational viscometer with a cone plate (diameter, 50 mm; cone angle, 1 °) at a temperature of 25.0°C, at shear rate of 10 $s^{-1}$ and 1,000 $s^{-1}$, respectively.

The shear viscosity at the shear rate of 10 $s^{-1}$ ($\eta 1$) was 40 Pa.s, and the shear viscosity at a shear rate of 1,000 $s^{-1}$ ($\eta 2$) was 0.5 Pa.s. A thixotropic ratio of shear viscosity of 10 $s^{-1}$ and 1,000 $s^{-1}$ ($\eta 1/\eta 2$) was 80.

(Measurement of effective lifetime and thickness of passivation layer)

A passivation layer was formed and evaluated in the same manner as in Comparative Example 1, except that 37.9 mg of a composition for forming a passivation layer 6 was applied on a pre-treated silicon substrate in a square, 4.5 cm on a side. The applied amount of the aluminum compound was 12.0 mg. The effective lifetime was 227 μs. The surface was covered with a black residue. The thickness of a passivation layer after removing a residue by blowing was 752 mm.

<Comparative Example 3>

A passivation layer was prepared and evaluated in the same manner as in Comparative Example 1, except that 29.0 mg of a composition for forming a passivation layer 6 was applied on a pre-treated silicon substrate in a square, 4.5 cm on a side. The applied aluminum compound was 9.2 mg. The effective lifetime was 173 μs. The surface was covered with a black residue. The thickness of the passivation layer after removing the residue by blowing was 526 nm.

<Comparative Example 4>

(Preparation of composition for forming passivation layer 7)

10.00 g of ethyl acetoacetate aluminum diisopropylate and 25.53 g of terpineol were mixed, and then 34.71 g of 10% by mass ethyl cellulose solution of comparative example 1 was mixed to prepare a composition for forming a passivation layer 7 as clear and colorless solution. The content ratio of ethyl cellulose in the composition for forming a passivation layer 7 was 4.9% by mass, and the content ratio of the aluminum compound was 14.2% by mass.

(Thixotropic ratio)

Shear viscosity of a composition for forming a passivation layer 7 prepared above was measured immediately after preparation (within 12 hours) using a rotational viscometer with a cone plate (diameter, 50 mm; cone angle, 1°) at a temperature of 25.0°C, at shear rate of 10 $s^{-1}$ and 1,000 $s^{-1}$, respectively.

The shear viscosity at the shear rate of 10 $s^{-1}$ ($\eta 1$) was 30 Pa.s, and the shear viscosity at a shear rate of 1,000 $s^{-1}$ ($\eta 2$) was 0.3 Pa.s. A thixotropic ratio of shear viscosity of 10 $s^{-1}$ and 1,000 $s^{-1}$ ($\eta 1/\eta 2$) was 100.

(Measurement of effective lifetime and thickness of passivation layer)

A passivation layer is formed and evaluated in the same manner as in Comparative Example 1, except that 37.9 mg of a composition for forming a passivation layer 6 was applied on a pre-treated silicon substrate in a square-shape, 4.5 cm on a side. The applied amount of the aluminum compound was 5.4 mg. The effective lifetime was 168 μs. The surface was covered with a black residue. The thickness of the passivation layer after the residue was removed by blowing was 311 nm.

<Comparative Example 5>

A passivation layer was prepared and evaluated in the same manner as in Comparative Example 1, except that 28.0 mg of the above-described composition for forming a passivation layer 7 was applied on a pretreated substrate in a square-shape, 4.5 cm on a side. The applied aluminum compound was 4.0 mg. The effective lifetime was 170 μs. The surface was covered with a black residue. The thickness of the passivation layer after the residue was removed by blowing was 227 nm.

Results of Examples 1 to 8 and Comparative Examples 1 to 5 are collectively shown in Tables 1 and 2.

Table 1

| Item | | | Example 1 | Example 2 | Example 3 | Example 4 | Example 5 | Example 6 | Example 7 | Example 8 |
|---|---|---|---|---|---|---|---|---|---|---|
| Composition for Forming Passivation Layer of Semiconductor Substrate | | | 1 | 1 | 2 | 2 | 3 | 3 | 4 | 4 |
| Component | AL | ALCH (g) | 2.9 | 2.9 | 1.64 | 1.64 | 0.85 | 0.85 | 0.21 | 0.21 |
| | | ALCH Content in Composition (%) | 14.9 | 14.9 | 10.7 | 10.7 | 5.6 | 5.6 | 1.3 | 1.3 |
| | TERUSOLV | TERUSOLV MTPH (g) | 13.33 | 13.33 | 12.02 | 12.02 | 12.69 | 12.69 | 13.52 | 13.52 |
| | | TERUSOLV MTPH Content in Composition (%) | 68.7 | 68.7 | 78.6 | 78.6 | 83.4 | 83.4 | 86.7 | 86.7 |
| | Solvent | Terpineol (g) | 3.18 | 3.18 | 1.63 | 1.63 | 1.67 | 1.67 | 1.87 | 1.87 |
| | | Terpineol Content in Composition (%) | 16.4 | 16.4 | 10.7 | 10.7 | 11 | 11 | 12 | 12 |
| | Resin Binder | 10% Ethyl Cellulose Solution (g) | 0 | 0 | 0 | 0 | 0 | 0 | 0 | 0 |
| | | Ethyl Cellulose Content in Composition (%) | 0 | 0 | 0 | 0 | 0 | 0 | 0 | 0 |
| Composition | Shear | η1 (Pa·s) | 30 | 30 | 26 | 26 | 25 | 25 | 24 | 24 |
| Properties | Viscosity | η2 (Pa·s) | 13 | 13 | 12 | 12 | 11 | 11 | 10 | 10 |
| | Thixotropic Ratio | η1/η2 | 2.3 | 2.3 | 2.2 | 2.2 | 2.3 | 2.3 | 2.4 | 2.4 |
| Film Formation | Applying | Applied Amount (mg) | 42.4 | 30.7 | 50.1 | 38.1 | 48.0 | 37.0 | 54.5 | 37.6 |
| | | Aluminum Compound in Applied Composition (mg) | 6.3 | 4.6 | 5.4 | 4.1 | 2.7 | 2.1 | 0.7 | 0.5 |
| | Drying | Temperature (°C) | 240 | 240 | 240 | 240 | 240 | 240 | 240 | 240 |
| | | Time (min) | 5 | 5 | 5 | 5 | 5 | 5 | 5 | 5 |
| | Calcination | Temperature (°C) | 800 | 800 | 800 | 800 | 800 | 800 | 800 | 800 |
| | | Time (minutes) | 10 | 10 | 10 | 10 | 10 | 10 | 10 | 10 |
| Evaluation | Film Properties | Effective Lifetime (μs) | 405 | 330 | 305 | 281 | 310 | 271 | 250 | 264 |
| | | Film Thickness (nm) | 314 | 230 | 232 | 209 | 139 | 148 | 66 | 80 |
| | Residue | Existence of Residue | No | No | No | No | No | No | No | No |

Table 2

| Item | | | Comparative Example | | | | |
|---|---|---|---|---|---|---|---|
| | | | 1 | 2 | 3 | 4 | 5 |
| Composition for Forming Passivation Film of Semiconductor Substrate | | | 5 | 6 | 6 | 7 | 7 |
| Component | AL | ALCH (g) | 24.91 | 30.12 | 30.12 | 10.0 | 10.0 |
| | | Content ofALCH in Composition (%) | 38.2 | 31.6 | 31.6 | 14.2 | 14.2 |
| | TERUSOLV | TERUSOLV MTPH (g) | 0 | 0 | 0 | 0 | 0 |
| | | TERUSOLV MTPH Content in Composition (%) | 0 | 0 | 0 | 0 | 0 |
| | Solvent | Terpineol (g) | 15.21 | 15.0 | 15.0 | 25.53 | 25.53 |
| | | Terpineol Content in Composition (%) | 58.0 | 63.1 | 63.1 | 80.9 | 80.9 |
| | Resin Binder | 10% Ethyl Cellulose Solution(g) | 25.05 | 50.1 | 50.1 | 34.71 | 34.71 |
| | | Ethyl Cellulose Content in Composition (%) | 3.8 | 5.3 | 5.3 | 4.9 | 4.9 |
| Composition | Shear | η1 (Pa·s) | 45 | 40 | 40 | 30 | 30 |
| Properties | Viscosity | η2 (Pa·s) | 1.2 | 0.5 | 0.5 | 0.3 | 0.3 |
| | Thixotropic ratio | η1/η2 | 38 | 80 | 80 | 100 | 100 |
| Film Forming | Applying | Applied Amount (mg) | 42.3 | 37.9 | 29.0 | 37.9 | 28.0 |
| | | Aluminum Compound in Applied Composition (mg) | 16.2 | 12.0 | 9.2 | 5.4 | 4.0 |
| | Drying | Temperature (°C) | 150 | 150 | 150 | 150 | 150 |
| | | Time (minute) | 3 | 3 | 3 | 3 | 3 |
| | Calcination | Temperature (°C) | 800 | 800 | 800 | 800 | 800 |
| | | Time (minute) | 10 | 10 | 10 | 10 | 10 |
| Evaluation | Film properties | Effective Lifetime (μs) | 233 | 227 | 173 | 168 | 170 |
| | | Film Thickness (nm) | 52 | 752 | 526 | 311 | 227 |
| | Residue | Existence of Residue | Yes | Yes | Yes | Yes | Yes |

As shown in Example 1 to 8, when the composition for forming a passivation layer including a specific organic compound represented by Formula (II) is used, it was found that a passivation layer having favorable lifetime can be formed without a black residue. On the other hand, a black residue occurred after thermal treatment (calcination) and effective lifetime was short in Comparative Examples 1 to 5 which do not contain a specific organic compound represented by Formula (II).

The disclosure of Japanese Patent Application Publication No. 2012-156472 is incorporated herein by reference in its entirety.

All literatures, patent applications, and technical standards described in this specification are incorporated herein by reference to the same extent as if each individual literature, patent application and technical standard were specifically and individually indicated as being incorporated by reference.

## Claims

1. A composition for forming a passivation layer, comprising an organic aluminum compound represented by the following Formula (I) and an organic compound represented by the following Formula (II):

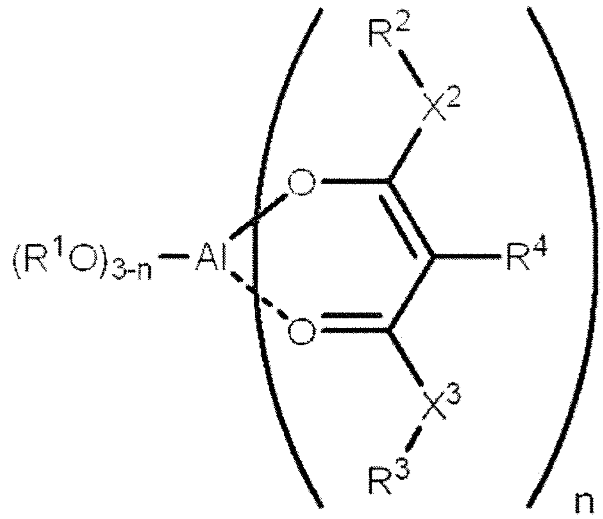

(I)

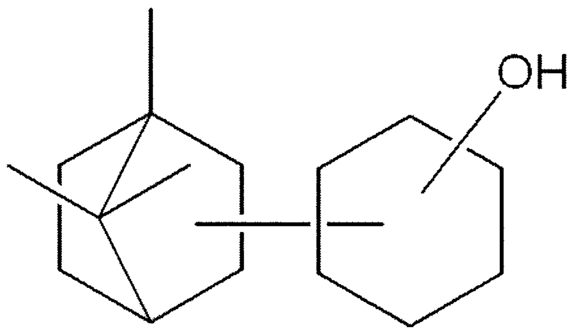

(II)

wherein in Formula (I), each $R^1$ independently represents an alkyl group having from 1 to 8 carbon atoms; n represents an integer from 0 to 3; each of $X^2$ and $X^3$ independently represents an oxygen atom or a methylene group; each of $R^2$, $R^3$, and $R^4$ independently represents a hydrogen atom or an alkyl group having from 1 to 8 carbon atoms.

2. The composition for forming a passivation layer according to claim 1, wherein each $R^1$ in Formula (I) independently represents an alkyl group having from 1 to 4 carbon atoms.

3. The composition for forming a passivation layer according to claim 1 or 2, wherein n in Formula (I) is an integer from 1 to 3.

4. The composition for forming a passivation layer according to any one of claims 1 to 3, wherein the content ratio of Formula (II) is from 30% by mass to 99.9% by mass with respect to 100% by mass of the composition for forming a passivation layer.

5. A semiconductor substrate with a passivation layer, comprising:

   a semiconductor substrate; and
   a passivation layer, which is provided on an entire or partial surface of the semiconductor substrate, and which is a resultant of subjecting the composition for forming a passivation layer according to any one of claims 1 to 4 to a thermal treatment.

6. A method of producing a semiconductor substrate with a passivation layer, comprising:

applying the composition for forming a passivation layer according to any one of claims 1 to 4 onto an entire or partial surface of a semiconductor substrate to form a composition layer; and
subjecting the composition layer to a thermal treatment to form a passivation layer.

**7.** A photovoltaic cell element, comprising:

a semiconductor substrate composed of a p-type layer and an n-type layer connected by a p-n junction;
a passivation layer, which is provided on an entire or partial surface of the semiconductor substrate, and which is a resultant of subjecting the composition for forming a passivation layer according to any one of claims 1 to 4 to a thermal treatment; and
an electrode provided on one or more layers selected from the group consisting of the p-type layer and the n-type layer.

**8.** A method of producing a photovoltaic cell element, comprising:

applying the composition for forming a passivation layer according to any one of claims 1 to 4 onto at least a portion of a surface having an electrode of a semiconductor substrate, the semiconductor substrate comprising a p-n junction composed of a p-type layer and an n-type layer that are connected, and the electrode on one or more layers selected from the group consisting of the p-type layer and the n-type layer; and
subjecting the composition layer to a thermal treatment to form a passivation layer.

**9.** A photovoltaic cell, comprising:

the photovoltaic cell element according to claim 7; and
a wiring material provided on an electrode of the photovoltaic cell element.

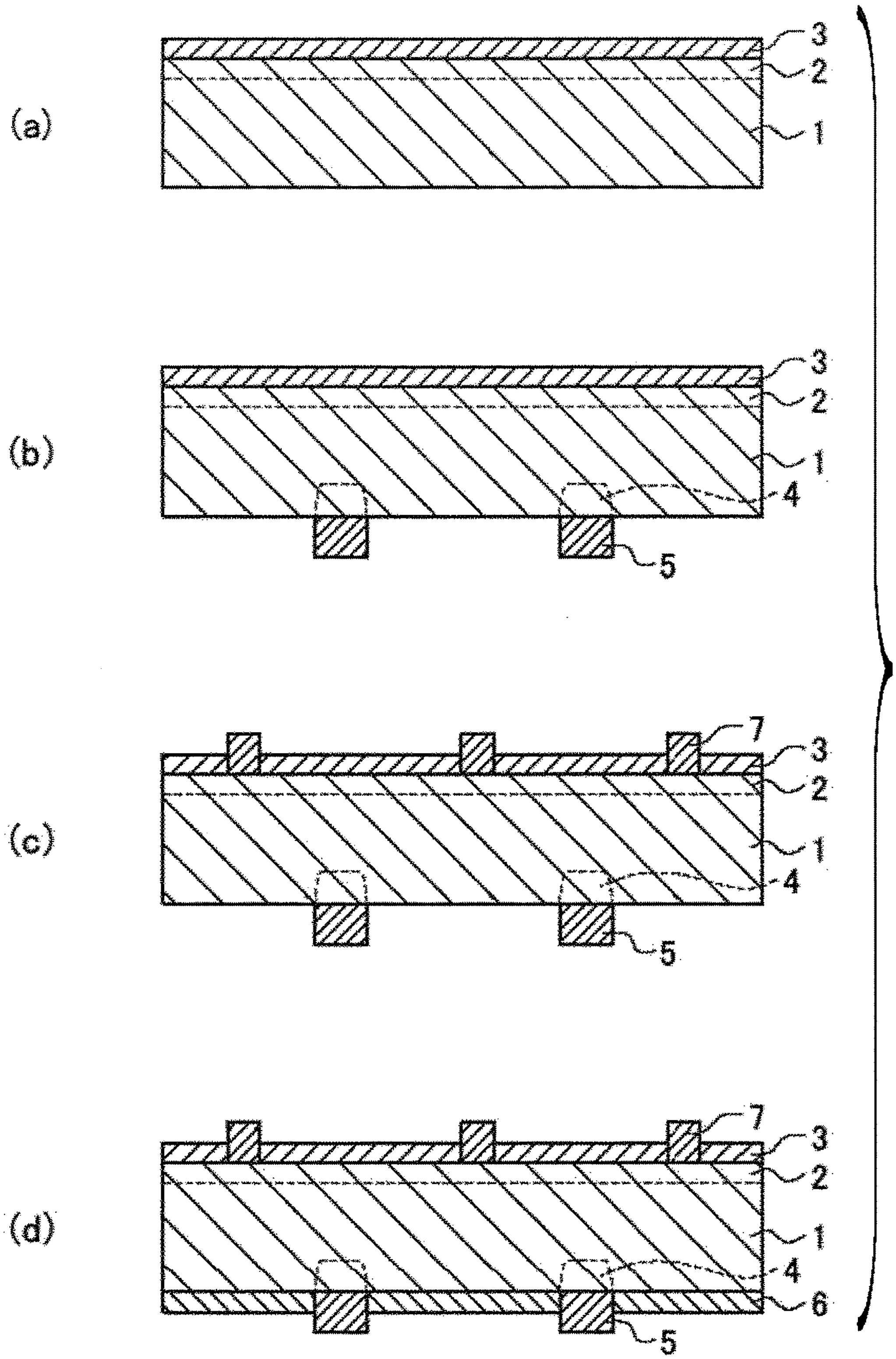


FIG.1

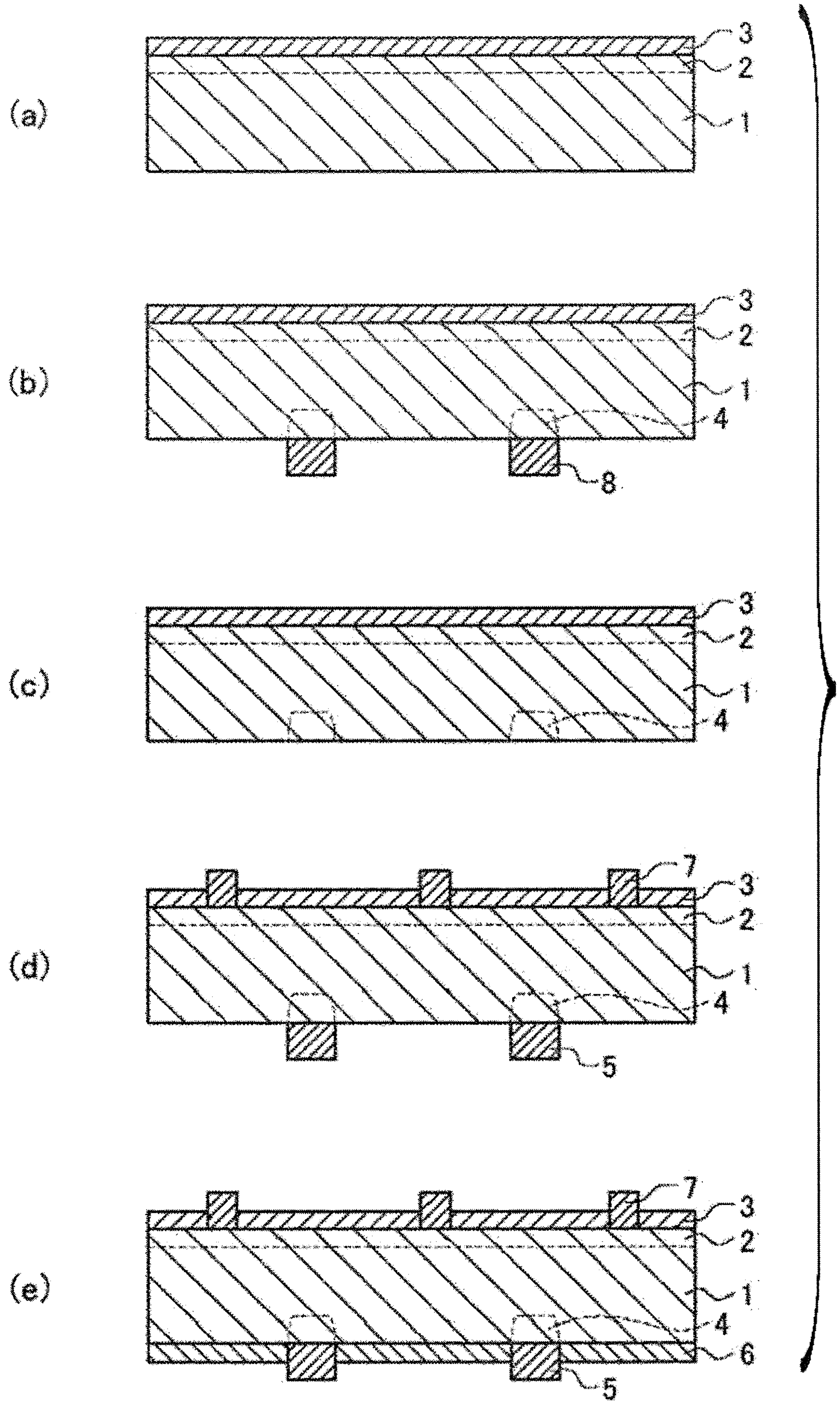


FIG.2

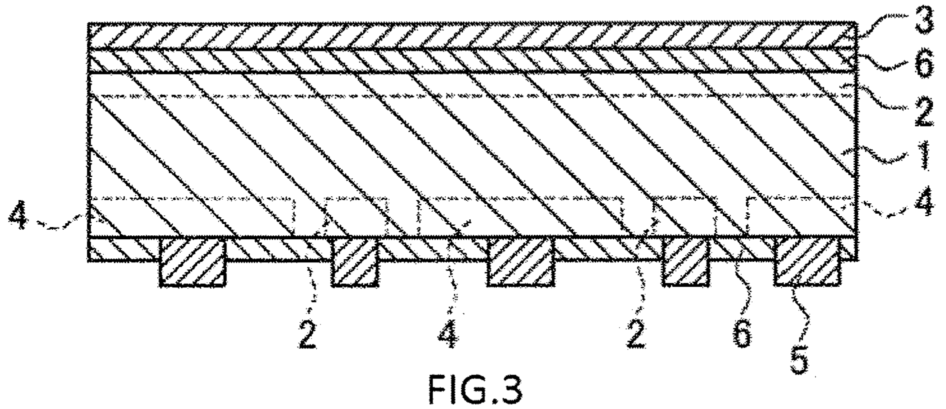


FIG.3

## INTERNATIONAL SEARCH REPORT

International application No.
PCT/JP2013/069223

A. CLASSIFICATION OF SUBJECT MATTER
*H01L21/316*(2006.01)i, *H01L21/312*(2006.01)i, *H01L31/04*(2006.01)i

According to International Patent Classification (IPC) or to both national classification and IPC

B. FIELDS SEARCHED

Minimum documentation searched (classification system followed by classification symbols)
H01L21/316, H01L21/312, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2007/046432 A1 (Matsushita Electric Industrial Co., Ltd.), 26 April 2007 (26.04.2007), paragraphs [0015] to [0123] & US 2009/0263648 A1 & US 2013/0078457 A1 & CN 101291876 A | 1,2,5,6<br>3,7-9 |
| Y | JP 2012-23084 A (The Yokohama Rubber Co., Ltd.), 02 February 2012 (02.02.2012), paragraphs [0018] to [0100] (Family: none) | 3 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
03 October, 2013 (03.10.13)

Date of mailing of the international search report
15 October, 2013 (15.10.13)

Name and mailing address of the ISA/
Japanese Patent Office

Facsimile No.

Authorized officer

Telephone No.

Form PCT/ISA/210 (second sheet) (July 2009)

INTERNATIONAL SEARCH REPORT

International application No.
PCT/JP2013/069223

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | WO 2010/104070 A1 (Sekisui Chemical Co., Ltd.), 16 September 2010 (16.09.2010), paragraphs [0011] to [0182]<br>& US 2012/0000527 A1 & EP 2408016 A1<br>& TW 201039447 A | 7-9<br>4 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3107287 B
- JP 2004006565 A
- JP 4767110 B
- JP 2012156472 A

### Non-patent literature cited in the description

- *Journal ofApplied Physics,* 2008, vol. 104, 113, , 703-1, 113703-7
- *Thin Solid Films,* 2009, vol. 517, 6327-6330
- *Chinese Physics Letters,* 2009, vol. 26, 088102-1, 088102-4
- *Journal of Applied Physics,* 2008, vol. 104, 113703-1, 113, , 703-7
- *Nippon Seramikkusu Kyokai Gakujitsu Ronbunshi,* 1989, vol. 97, 369-399